(19) Europäisches Patentamt
European Patent Office
Office européen des brevets

(11) EP 4 317 337 A1

(12) EUROPEAN PATENT APPLICATION
published in accordance with Art. 153(4) EPC

(43) Date of publication:
**07.02.2024 Bulletin 2024/06**

(21) Application number: **22775475.1**

(22) Date of filing: **18.03.2022**

(51) International Patent Classification (IPC):
***C09G 1/02*** (2006.01) ***C09K 3/14*** (2006.01)
***B24B 37/00*** (2012.01) ***H01L 21/304*** (2006.01)

(52) Cooperative Patent Classification (CPC):
**B24B 37/00; C09G 1/02; C09K 3/14; H01L 21/304**

(86) International application number:
**PCT/JP2022/012724**

(87) International publication number:
**WO 2022/202688 (29.09.2022 Gazette 2022/39)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **26.03.2021 JP 2021052791**

(71) Applicant: **Fujimi Incorporated**
**Kiyosu-shi, Aichi 452-8502 (JP)**

(72) Inventors:
- **ICHITSUBO, Taiki**
  **Kiyosu-shi, Aichi 452-8502 (JP)**
- **TSUCHIYA, Kohsuke**
  **Kiyosu-shi, Aichi 452-8502 (JP)**

(74) Representative: **Grünecker Patent- und Rechtsanwälte PartG mbB**
**Leopoldstraße 4**
**80802 München (DE)**

# (54) POLISHING METHOD, METHOD FOR PRODUCING SEMICONDUCTOR SUBSTRATE, AND POLISHING COMPOSITION SET

(57) The present invention provides means capable of reducing surface defects on a polished substrate. The present invention relates to a method for polishing a substrate, in which the polishing method includes a polishing step, the polishing step includes two or more polishing sub-steps of polishing the substrate by rotating a platen while supplying a polishing composition to a contact surface between the substrate and a polishing pad attached to the platen, the two or more polishing sub-steps include a polishing sub-step 1 of performing polishing on the platen using a polishing composition S1, and a polishing sub-step 2 of performing, after the polishing sub-step 1, polishing on the platen used in the polishing sub-step 1 using a polishing composition S2, the polishing composition S1 contains an abrasive 1, water, and a water-soluble polymer having an abrasive adsorption parameter of 5 or more, and the polishing composition S2 contains an abrasive 2, water, and a water-soluble polymer having the abrasive adsorption parameter less than 5, but does not contain a water-soluble polymer having the abrasive adsorption parameter of 5 or more in a content of 0.005% by mass or more.

EP 4 317 337 A1

## Description

### TECHNICAL FIELD

The present invention relates to a polishing method, a method for producing a semiconductor substrate, and a polishing composition set.

### BACKGROUND ART

A surface of a semiconductor substrate such as a silicon wafer, or another substrate, used as a component of a semiconductor product or the like is finished into a high quality mirror surface generally through a lapping step (rough polishing step) and a polishing step (fine polishing step). As a polishing method performed in the polishing step, a chemical mechanical polishing method (CMP method) with a polishing slurry containing an abrasive in a liquid is widely employed. This polishing method relies on a combined effect of a mechanical polishing effect owing to the abrasive, and a chemical polishing effect owing to a component other than the abrasive, contained in the liquid, and it is known that a mirror surface excellent in smoothness, a low defect property and the like can be obtained by this method.

In order to realize high integration and high speed of an integrated circuit, such as a ULSI, used in a computer, design rules for semiconductor devices have been refined year by year. In accordance with this, a more minute surface defect harmfully affects performances of a semiconductor device in more and more cases, and it has become more significant to control a nanometer order defect, which was not considered a problem in conventional techniques.

In recent years, a semiconductor substrate such as a silicon wafer, and another substrate are required to have higher quality surfaces, and various examinations have been made on a polishing composition capable of meeting such a requirement. As such a technique, Japanese Patent Laid-Open No. 2017-183478 discloses a method for polishing a silicon wafer including, as continuous steps, a final polishing step, a pre-polishing step at one stage before the final polishing step, and a rinsing step, positioned between the final polishing step and the pre-polishing step, of rinsing the silicon wafer after the pre-polishing step. In this method, a pre-polishing composition and a rinsing agent are selected so that a hydrophilic parameter of the rinsing agent used for rinsing the silicon wafer in the rinsing step is smaller than a hydrophilic parameter of the pre-polishing composition used in the pre-polishing step. This literature also discloses that according to this method, in the polished silicon wafer, a high quality polished surface can be realized by reducing hazes and minute defects.

### SUMMARY OF INVENTION

In recent year, in a semiconductor substrate such as a silicon wafer, and another substrate, a requirement level for surface defect reduction has been increasing. In order to meet such a requirement, an object of the present invention is to provide means capable of reducing surface defects on a polished substrate.

An above problem of the present invention can be achieved by the following means:

A method for polishing a substrate including a polishing step, wherein the polishing step includes two or more polishing sub-steps of polishing the substrate by rotating a platen while supplying a polishing composition to a contact surface between the substrate and a polishing pad attached to the platen, the two or more polishing sub-steps include a polishing sub-step 1 of performing polishing on the platen using a polishing composition S1, and a polishing sub-step 2 of performing, after the polishing sub-step 1, polishing on the platen used in the polishing sub-step 1 using a polishing composition S2, the polishing composition S1 contains an abrasive 1, water, and a water-soluble polymer having an abrasive adsorption parameter calculated through the following procedures (1) to (4) of 5 or more, and the polishing composition S2 contains an abrasive 2, water, and a water-soluble polymer having the abrasive adsorption parameter less than 5, but does not contain a water-soluble polymer having the abrasive adsorption parameter of 5 or more in a content of 0.005% by mass or more:

(1) providing a test liquid L containing colloidal silica having an average primary particle size of 25 nm and an average secondary particle size of 50 nm in a concentration of 0.08% by mass, a water-soluble polymer to be measured in a concentration of 0.004% by mass, ammonia in a concentration of 0.005% by mass, and the balance of water,
(2) measuring a total organic carbon concentration (TOC value) of the test liquid L, and taking the obtained TOC value as a total organic carbon concentration $W_0$ of the water-soluble polymer to be measured contained in the test liquid L,
(3) subjecting the test liquid L to a centrifugation treatment at 26,000 rpm for 30 minutes to separate the test liquid L into a precipitate and a supernatant, then measuring a TOC value of the supernatant, and taking the obtained TOC value as a total organic carbon concentration $W_1$ of the water-soluble polymer to be measured contained in the supernatant, and

(4) calculating an adsorption ratio of the water-soluble polymer to be measured in accordance with the following equation, and taking a value thus obtained as the abrasive adsorption parameter.

[Expression 1]

$$\text{Adsorption Ratio (\%)} = [(W_0 - W_1)/W_0] \times 100$$

The above problem of the present invention can be achieved also by the following means:
A polishing composition set to be used in a method for polishing a substrate, wherein the polishing method includes a polishing step, the polishing step includes two or more polishing sub-steps of polishing the substrate by rotating a platen while supplying a polishing composition to a contact surface between the substrate and a polishing pad attached to the platen, the two or more polishing sub-steps include a polishing sub-step 1 of performing polishing on a platen, and a polishing sub-step 2 of performing, after the polishing sub-step 1, polishing on the platen used in the polishing sub-step 1, the polishing composition set including:

a polishing composition S1 for use in the polishing sub-step 1, containing an abrasive 1, water, and a water-soluble polymer having an abrasive adsorption parameter calculated through the following procedures (1) to (4) of 5 or more, and
a polishing composition S2 for use in the polishing sub-step 2, containing an abrasive 2, water, and a water-soluble polymer having the abrasive adsorption parameter less than 5, but not containing a water-soluble polymer having the abrasive adsorption parameter of 5 or more in a content of 0.005% by mass or more:

(1) providing a test liquid L containing colloidal silica having an average primary particle size of 25 nm and an average secondary particle size of 50 nm in a concentration of 0.08% by mass, water-soluble polymer to be measured in a concentration of 0.004% by mass, ammonia in a concentration of 0.005% by mass, and the balance of water,
(2) measuring a total organic carbon concentration (TOC value) of the test liquid L, and taking the obtained TOC value as a total organic carbon concentration $W_0$ of the water-soluble polymer to be measured contained in the test liquid L,
(3) subjecting the test liquid L to a centrifugation treatment at 26,000 rpm for 30 minutes to separate the test liquid L into a precipitate and a supernatant, then measuring a TOC value of the supernatant, and taking the obtained TOC value as a total organic carbon concentration $W_1$ of the water-soluble polymer to be measured contained in the supernatant, and
(4) calculating an adsorption ratio of the water-soluble polymer to be measured in accordance with the following equation, and taking a value thus obtained as the abrasive adsorption parameter.

[Expression 2]

$$\text{Adsorption Ratio (\%)} = [(W_0 - W_1)/W_0] \times 100$$

Embodiments of the present invention will now be described. It is noted that the present invention is not limited to the following embodiments. Operations and measurement of physical properties and the like are performed under conditions of room temperature (in a range of 20°C or more and 25°C or less)/relative humidity of 40% RH or more and 50% RH or less unless otherwise stated.
The term "(meth)acrylic acid" used herein is a general name for acrylic acid and methacrylic acid. Other compounds and the like containing "(meth)" are also general names for compounds having "meth" in their names and compounds not having "meth" in their names.

<Polishing Method>

One aspect of the present invention relates to a method for polishing a substrate, including a polishing step, wherein the polishing step includes two or more polishing sub-steps of polishing the substrate by rotating a platen while supplying a polishing composition to a contact surface between the substrate and a polishing pad attached to the platen, the two or more polishing sub-steps include a polishing sub-step 1 of performing polishing on the platen using a polishing composition S1, and a polishing sub-step 2 of performing, after the polishing sub-step 1, polishing on the platen used in the polishing sub-step 1 using a polishing composition S2, the polishing composition S1 contains an abrasive 1, water, and a water-soluble polymer having an abrasive adsorption parameter calculated through the following procedures (1) to (4) of 5 or more, and the polishing composition S2 contains an abrasive 2, water, and a water-soluble polymer having

the abrasive adsorption parameter less than 5, but does not contain a water-soluble polymer having the abrasive adsorption parameter of 5 or more in a content of 0.005% by mass or more (namely, a concentration of the water-soluble polymer having the abrasive adsorption parameter of 5 or more in the polishing composition S2 is less than 0.005% by mass with respect to the total mass of the polishing composition S2). The present aspect can provide means capable of reducing surface defects on a polished substrate.

The present inventors presume the mechanism for solving the problem by the present invention as follows. A water-soluble polymer having a large abrasive adsorption parameter is easily adsorbed onto silica and the like. First, in the polishing sub-step 1, a substrate is polished by using a polishing composition containing a water-soluble polymer having a large abrasive adsorption parameter. At this point, the water-soluble polymer having a large abrasive adsorption parameter adsorbs onto the abrasive and the substrate, and thus, the substrate is protected. Therefore, the substrate can be processed with damage on the substrate suppressed in the polishing sub-step 1. Subsequently, in the polishing sub-step 2, the substrate is polished by using a polishing composition containing a water-soluble polymer having a small abrasive adsorption parameter. At this point, the water-soluble polymer having a small abrasive adsorption parameter does not largely adsorb onto the abrasive but functions to remove the abrasive remaining on the substrate. Therefore, in the polishing sub-step 2, the substrate can be favorably cleaned. As a result of these, a substrate obtained after polishing performed by the polishing method of the present invention is less damaged, and the abrasive remain in a small amount on the substrate, and therefore, surface defects thereon are remarkably reduced. It is noted that the above-described mechanism is based on presumption, and the technical scope of the present invention is not affected by whether it is right or wrong.

The method for polishing a substrate according to one embodiment of the present invention includes a polishing step, the polishing step includes two or more polishing sub-steps of polishing the substrate by rotating a platen while supplying a polishing composition to a contact surface between the substrate and a polishing pad attached to the platen, and the two or more polishing sub-steps include a polishing sub-step 1 of performing polishing on the platen using a polishing composition S1, and a polishing sub-step 2 of performing, after the polishing sub-step 1, polishing on the platen used in the polishing sub-step 1 using a polishing composition S2.

[Polishing Step]

Hereinafter, the polishing step included in the polishing method according to one embodiment of the present invention will be described.

A polishing machine used in the polishing step of one embodiment of the present invention, and polishing conditions that can be employed in the polishing sub-step 1 and the polishing sub-step 2 will be described.

The polishing machine is not especially limited, and it is possible to use, for example, a general polishing machine that is equipped with a holding tool (holder) for holding a substrate or the like having an object to be polished, and a rotational speed-variable motor or the like, and includes a platen on which a polishing pad (polishing cloth) can be attached. For example, a single side polishing machine or a double side polishing machine can be used. An example of a commercially available polishing machine is not especially limited, and an example of the single side polishing machine includes Single Wafer Polishing machine "PNX 332B" manufactured by Okamoto Machine Tool Works, Ltd.

When an object to be polished is polished with a single side polishing machine, the object to be polished is held with a holding tool designated as a template, and with a platen having a polishing pad (polishing cloth) attached thereon pressed against one surface of the object to be polished, the platen is rotated while a polishing composition is supplied, and thus, the one surface of the object to be polished is polished.

When an object to be polished is polished with a double side polishing machine, the object to be polished is held with a holding tool designated as a carrier, and with platens having polishing pads (polishing cloths) attached thereon respectively pressed from both sides against both surfaces of the object to be polished, the platens of the both sides are rotated while a polishing composition is supplied, and thus, the both surfaces of the object to be polished are polished.

When such a polishing machine is used, with the polishing composition supplied to the contact surface between the substrate and the polishing pad attached to the platen, the platen is rotated to polish the substrate.

In this manner, the polishing performed in the polishing step may be either of single side polishing and double side polishing, and is preferably single side polishing.

As the polishing pad, a general one of nonwoven fabric type, polyurethane type, suede type or the like can be used without limitation. As the polishing pad, one having been grooved for holding the polishing composition thereon can be used. An example of a commercially available polishing pad is not especially limited, and an example of the nonwoven fabric type includes a trade name "FP55" manufactured by FUJIBO EHIME Co., Ltd., and an example of the suede type includes a trade name "POLYPAS275NX" manufactured by FUJIBO EHIME Co., Ltd.

Regarding the polishing conditions, favorable ranges vary depending on the purpose of the polishing performed in each polishing sub-step. Therefore, the polishing conditions are not especially limited, and suitable conditions according to the purpose of the polishing performed in each polishing sub-step can be employed.

The polishing is performed preferably by rotating the platen (platen), and more preferably by relatively moving (for example, rotationally moving) the substrate and the platen (platen). The rotational speed of the platen (platen) and the rotational speed of a head (carrier or template) are not especially limited, and are respectively independently preferably 10 rpm (0.17 $s^{-1}$) or more and 100 rpm (1.67 $s^{-1}$) or less, more preferably 20 rpm (0.33 $s^{-1}$) or more and 60 rpm (1 $s^{-1}$) or less, and further preferably 25 rpm (0.42 $s^{-1}$) or more and 55 rpm (0.92 $s^{-1}$) or less. When the rotational speeds are within such ranges, surface defects caused on the polished surface of the substrate are further reduced, and production efficiency is further improved. Besides, the rotational speed of the platen (platen) and the rotational speed of the head (carrier, template) may be the same or different.

The substrate is usually pressed by the platen. A pressure (polishing load) applied here is not especially limited, and is preferably 5 kPa or more and 30 kPa or less, and more preferably 10 kPa or more and 25 kPa or less. When the pressure is within such a range, surface defects caused on the polished surface of the substrate are further reduced, and the production efficiency is further improved.

Each polishing composition may be in a concentrated form before being supplied to the object to be polished. A concentrated form refers to a form of a concentrate of the polishing composition, and can be grasped as a stock solution of the polishing composition. A polishing composition in such a concentrated form is advantageous from the viewpoints of convenience, cost reduction and the like in production, distribution, storage and the like. The concentration factor is not especially limited, and can be, for example, about twice or more and 100 times or less in terms of volume, and is suitable to be usually about 5 times or more and 50 times or less, and for example, 10 times or more and 40 times or less. Such a concentrate can be used in such a manner as to be diluted at desired timing to prepare a polishing composition, and to supply the polishing composition to an object to be polished. Dilution can be performed, for example, by adding water to the concentrate to be mixed.

The supply rate of the polishing composition is not especially limited because it can be appropriately selected in accordance with the size of the platen, and is preferably a supply amount sufficient for covering the whole of the object to be polished. In consideration of economic performance, the supply rate of the polishing composition is more preferably 0.1 L/min or more and 5 L/min or less, and further preferably 0.2 L/min or more and 2 L/min or less. When the supply rate is within such a range, surface defects caused on the polished surface of the substrate are further reduced, and production efficiency is further improved.

The method for supplying the polishing composition is also not especially limited, and a continuous supplying method with a pump or the like (free-flow) may be employed.

A temperature for holding the polishing composition in the polishing machine is also not especially limited, and from the viewpoints of stability in the polishing removal rate and the effect of reducing surface defects caused on the polished surface of the substrate, is preferably 15°C or more and 40°C or less, and more preferably 18°C or more and 25°C or less.

Besides, the polishing composition may be collected after being used in the polishing of the object to be polished, and used again for polishing an object to be polished after adjusting, if necessary, the composition by adding respective components that can be contained in the polishing composition.

The polishing step may further include, in addition to the polishing sub-step 1 and the polishing sub-step 2, other polishing sub-steps if necessary, and preferably further includes other polishing sub-steps. At this point, the positions of the polishing sub-step 1 and the polishing sub-step 2 are not especially limited, and it is preferable that the polishing sub-step 1 is a polishing sub-step positioned one before the polishing sub-step 2, and it is more preferable that the polishing sub-step 1 is a polishing sub-step positioned one before a final polishing sub-step and that the polishing sub-step 2 is the final polishing sub-step. The number of polishing sub-steps included in the polishing step is preferably 2 or more and 10 or less, and more preferably 3 or more and 6 or less.

In the polishing sub-step 1 and the polishing sub-step 2, the substrate is polished on the same platen. It is noted that when the polishing step includes other polishing sub-steps in addition to the polishing sub-step 1 and the polishing sub-step 2, the substrate may be polished in other polishing sub-steps on the platen used in the polishing sub-step 1 and the polishing sub-step 2, or may be polished on a platen different from that used in the polishing sub-step 1 and the polishing sub-step 2, and it is preferable that the substrate is polished in other polishing sub-steps on a platen different from that used in the polishing sub-step 1 and the polishing sub-step 2.

It does not matter which type of polishing is performed in each of the polishing sub-step 1 and the polishing sub-step 2. It is, however, preferable that the polishing sub-step 1 is a polishing sub-step of performing final polishing, and that the polishing sub-step 2 is a polishing sub-step of performing rinse polishing. The polishing sub-step of performing final polishing refers to a polishing sub-step in which a substrate having been roughly polished through a polishing sub-step of performing pre-polishing such as stock polishing is more finely polished. Besides, the polishing sub-step of performing rinse polishing refers to a polishing sub-step, performed on a platen having a polishing pad attached thereto, in which residues remaining on a surface of the polished object to be polished are removed by a frictional force (physical function) of the polishing pad, and a function of a polishing composition (rinse polishing composition). Therefore, the polishing composition S2 is preferably a rinse polishing composition.

Accordingly, in one preferable embodiment of the present invention, the polishing step includes the polishing sub-step 1, the polishing sub-step 2, and further one, two or more other polishing sub-steps disposed before the polishing sub-step 1, and in addition, the polishing sub-step 1 is a polishing sub-step, disposed one before a final polishing sub-step, for performing final polishing, and the polishing sub-step 2 is the final polishing sub-step, and is a polishing sub-step of performing rinse polishing.

The relationship between a polishing time of the polishing sub-step 1 and a polishing time of the polishing sub-step 2 is not especially limited, and it is preferable that the polishing time of the polishing sub-step 2 is shorter than the polishing time of the polishing sub-step 1. In this case, surface defects caused on the polished surface of the substrate are further reduced.

The polishing time of the polishing sub-step 1 is not especially limited, and is preferably over 80 seconds, more preferably 100 seconds or more, and further preferably 150 seconds or more. When the polishing time is within such a range, surface defects caused on the polished surface of the substrate are further reduced. The polishing time of the polishing sub-step 1 is not especially limited, and is preferably 500 seconds or less, more preferably 300 seconds or less, and further preferably 250 seconds or less. When the polishing time is within such a range, production efficiency is improved.

The polishing time of the polishing sub-step 2 is not especially limited, and is preferably 1 second or more, more preferably 3 seconds or more, and further preferably 5 seconds or more. When the polishing time is within such a range, surface defects caused on the polished surface of the substrate are further reduced. Besides, the polishing time of the polishing sub-step 2 is not especially limited, and is preferably 80 seconds or less, more preferably 60 seconds or less, and further preferably 40 seconds or less. When the polishing time is within such a range, production efficiency is further improved.

The polishing machine and the polishing conditions described so far are merely exemplarily described, those out of the above-described ranges may be employed, and setting can be appropriately changed.

[Other Step]

The polishing method according to one embodiment of the present invention may further include other steps. An example of other steps includes a cleaning step.

The cleaning step may be provided at any timing of before the polishing step, during the polishing step, and after the polishing step. It is, however, preferable that the cleaning step is performed after the polishing step for subjecting the substrate to a cleaning treatment in the cleaning step. A cleaning method employed in the cleaning step is not especially limited, and in a preferable example of the method, a first cleaning tank holding a cleaning liquid and a second cleaning tank holding a cleaning liquid are provided, a substrate having been polished through the polishing step is immersed in the first cleaning tank, and thereafter in the second cleaning tank, and these immersion is repeated if necessary. An immersion time in the first cleaning tank (an immersion time in each time of immersion if the immersion is performed a plurality of times) is not especially limited, and is, for example, 1 minute or more and 10 minutes or less. Besides, an immersion time in the second cleaning tank (an immersion time in each time of immersion if the immersion is performed a plurality of times) is not especially limited, and is, for example, 1 minute or more and 30 minutes or less. The cleaning liquid is not especially limited, and examples include pure water, and a liquid of $NH_4OH$ (29% by mass) :$H_2O_2$ (31% by mass) :deionized water (DIW) = 2:5.3:48 (in a volume ratio). It is preferable that the cleaning liquid held in the first cleaning tank is a liquid of $NH_4OH$ (29% by mass) :$H_2O_2$ (31% by mass):deionized water (DIW) = 2:5.3:48 (in a volume ratio), and that the cleaning liquid held in the second cleaning tank is pure water. At this point, the cleaning liquid held in the second cleaning tank is more preferably ultrapure water of 25°C. The immersion in the cleaning liquid may be performed in a state where an ultrasonic oscillator is operated. Besides, the temperature of the cleaning liquid is not especially limited, and is preferably in a range of 40°C or more and 80°C or less. It is noted that the substrate is preferably dried with a known dryer such as a spin dryer after the cleaning.

[Polishing Composition]

Hereinafter, the polishing composition S1 and the polishing composition S2 used in the polishing method according to one aspect of the present invention will be described. Besides, a polishing composition S1 and a polishing composition S2 contained in a polishing composition set according to another aspect of the present invention described later will be described.

(Abrasive)

The polishing composition S1 and the polishing composition S2 contain an abrasive. Herein, the abrasive contained in the polishing composition S1 are referred to as the abrasive 1, and the abrasive contained in the polishing

composition S2 are referred to as the abrasive 2. The abrasive 1 functions to physically polish the surface of the substrate. The abrasive 2 functions to physically reduce residues on the surface of the substrate.

The abrasive is not especially limited, and examples include inorganic particles, organic particles, and organic-inorganic composite particles. Specific examples of the inorganic particles are not especially limited, and include particles of oxides (oxide particles) such as silica, alumina, cerium oxide, chromium oxide, titanium dioxide, zirconium oxide, magnesium oxide, manganese dioxide, zinc oxide, and red iron oxide, particles of nitrides (nitride particles) such as silicon nitride and boron nitride, particles of carbides (carbide particles) such as silicon carbide and boron carbide, particles of diamond, and particles of carbonates such as calcium carbonate and barium carbonate. Specific examples of the organic particles are not especially limited, and include particles of methyl polymethacrylate (PMMA). Other examples include particles containing one, two or more of the above-described substances. Among these, silica is preferred. In other words, the abrasive 1 and the abrasive 2 are preferably silica. Specific examples of the silica include colloidal silica, fumed silica, and sol-gel silica. Among these, from the viewpoint of further reducing surface defects caused on a polished surface of a substrate, colloidal silica or fumed silica is preferred, and colloidal silica is more preferred. The abrasive 1 and the abrasive 2 preferably respectively contain at least one selected from the group consisting of the above-described particles.

The average primary particle size of the abrasive is not especially limited, and is preferably 1 nm or more, more preferably 5 nm or more, further preferably 10 nm or more, and particularly preferably 20 nm or more. When the particle size is within such a range, the polishing removal rate is improved. Besides, the average primary particle size of the abrasive is not especially limited, and is preferably 100 nm or less, more preferably 70 nm or less, further preferably 50 nm or less, and particularly preferably 30 nm or less. When the particle size is within such a range, surface defects caused on the polished surface of the substrate are further reduced. A value of the average primary particle size of the abrasive is calculated, for example, based on a specific surface area measured by a BET method. The specific surface area of the abrasive can be measured, for example, using "Flow Sorb II 2300" manufactured by Micromeritics Instruments Corporation. Examples of the preferable range of the average primary particle size of the abrasive include, but are not limited to, 1 nm or more and 100 nm or less, 5 nm or more and 70 nm or less, 10 nm or more and 50 nm or less, and 20 nm or more and 30 nm or less.

The relationship between the average primary particle size of the abrasive 1 and the average primary particle size of the abrasive 2 is not especially limited, and it is preferable that the average primary particle size of the abrasive 2 is equal to or smaller than the average primary particle size of the abrasive 1. Besides, a ratio of the average primary particle size of the abrasive 2 to the average primary particle size of the abrasive 1 (average primary particle size of the abrasive 2/average primary particle size of the abrasive 1) is not especially limited, and is preferably 0.1 or more and 1 or less, more preferably 0.4 or more and 1 or less, further preferably 0.8 or more and 1 or less, and particularly preferably 1. In such a case, surface defects caused on the polished surface of the substrate are further reduced.

The average secondary particle size of the abrasive is not especially limited, and is preferably 10 nm or more, more preferably 20 nm or more, and further preferably 30 nm or more. When the particle size is within such a range, the polishing removal rate is improved. Besides, the average secondary particle size of the abrasive is not especially limited, and is preferably 200 nm or less, more preferably 150 nm or less, and further preferably 100 nm or less. When the particle size is within such a range, surface defects caused on the polished surface of the substrate are further reduced. A value of the average secondary particle size of the abrasive can be measured, for example, by a dynamic light scattering method using Model "UPA-UT151" manufactured by Nikkiso Co., Ltd. Examples of the preferable range of the average secondary particle size of the abrasive include, but are not limited to, 10 nm or more and 200 nm or less, 20 nm or more and 150 nm or less, and 30 nm or more and 100 nm or less.

An average degree of association of the abrasive is not especially limited, and is preferably 1.2 or more, more preferably 1.4 or more, and further preferably 1.5 or more. Herein, the average degree of association refers to a value obtained by dividing the value of the average secondary particle size of the abrasive by the value of the average primary particle size. When the average degree of association is within such a range, the polishing removal rate is further improved. Besides, the average degree of association of the abrasive is not especially limited, and is preferably 4 or less, more preferably 3.5 or less, and further preferably 3 or less. When the average degree of association is within such a range, surface defects caused on the polished surface of the substrate are further reduced. Examples of the preferable range of the degree of association of the abrasive include, but are not limited to, 1.2 or more and 4 or less, 1.4 or more and 3.5 or less, and 1.5 or more and 3 or less.

As the abrasive, a commercially available product may be used, or a synthesized product may be used. One type of abrasive may be singly used, or two or more types may be used in combination.

The concentration of the abrasive 1 in the polishing composition S1 is not especially limited, and is preferably 0.001% by mass or more, more preferably 0.01% by mass or more, and further preferably 0.05% by mass or more with respect to the total mass of the polishing composition S1. When the concentration is within such a range, the polishing removal rate is improved. Besides, the concentration of the abrasive 1 in the polishing composition S1 is not especially limited, and is preferably 3% by mass or less, more preferably 1% by mass or less, further preferably 0.5% by mass or

less, still further preferably 0.1% by mass or less, and particularly preferably 0.08% by mass or less with respect to the total mass of the polishing composition S1. When the concentration is within such a range, surface defects caused on the polished surface of the substrate are further reduced. Examples of the preferable range of the concentration of the abrasive 1 in the polishing composition S1 include, but are not limited to, 0.001% by mass or more and 3% by mass or less, 0.01% by mass or more and 1% by mass or less, 0.05% by mass or more and 0.5% by mass or less, 0.05% by mass or more and 0.1% by mass or less, and 0.05% by mass or more and 0.08% by mass or less with respect to the total mass of the polishing composition S1.

The concentration of the abrasive 2 in the polishing composition S2 is not especially limited, and is preferably 0.001% by mass or more, and more preferably 0.01% by mass or more with respect to the total mass of the polishing composition S2. When the concentration is within such a range, the polishing removal rate is improved. Besides, the concentration of the abrasive 2 in the polishing composition S2 is not especially limited, and is preferably 3% by mass or less, more preferably 1% by mass or less, further preferably 0.5% by mass or less, still further preferably 0.1% by mass or less, and particularly preferably 0.08% by mass or less with respect to the total mass of the polishing composition S2. When the concentration is within such a range, surface defects caused on the polished surface of the substrate are further reduced. Examples of the preferable concentration of the abrasive 2 in the polishing composition S2 include, but are not limited to, 0.001% by mass or more and 3% by mass or less, 0.01% by mass or more and 1% by mass or less, 0.01% by mass or more and 0.5% by mass or less, 0.01% by mass or more and 0.1% by mass or less, and 0.01% by mass or more and 0.08% by mass or less with respect to the total mass of the polishing composition S2.

Accordingly, in one preferable embodiment of the present invention, the concentration of the abrasive 1 in the polishing composition S1 is 0.001% by mass or more and 3% by mass or less with respect to the total mass of the polishing composition S1, and the concentration of the abrasive 2 in the polishing composition S2 is 0.001% by mass or more and 3% by mass or less with respect to the total mass of the polishing composition S2.

The relationship between the concentration of the abrasive 2 in the polishing composition S2 and the concentration of the abrasive 1 in the polishing composition S1 is not especially limited, and it is preferable that the concentration of the abrasive 2 in the polishing composition S2 is equal to or lower than the concentration of the abrasive 1 in the polishing composition S1. Besides, a ratio of the concentration of the abrasive 2 in the polishing composition S2 to the concentration of the abrasive 1 in the polishing composition S1 (concentration of the abrasive 2 in the polishing composition S2/concentration of the abrasive 1 in the polishing composition S1) is not especially limited, and is preferably 0.1 or more and 1 or less, and more preferably 0.4 or more and 1 or less. In such a case, surface defects caused on the polished surface of the substrate can be further reduced. The ratio can be, for example, 0.8 or more and 1 or less, and can be, for example, 1.

(Water-soluble Polymer)

The polishing composition S1 and the polishing composition S2 contains a water-soluble polymer. Herein, the term "water-soluble" means that solubility in water (25°C) is 1 g/100 mL or more, and the term "polymer" refers to a compound having a weight average molecular weight of 1,000 or more. The weight average molecular weight can be measured by gel permeation chromatography (GPC) in terms of polyoxyethylene. Specifically, a value measured by a method described in Examples can be employed.

The polishing composition S1 contains a water-soluble polymer having an abrasive adsorption parameter calculated through procedures (1) to (4) described below (herein, also simply referred to as the "abrasive adsorption parameter") of 5 or more. The polishing composition S1 preferably further contains a water-soluble polymer having the abrasive adsorption parameter less than 5. Besides, the polishing composition S2 contains a water-soluble polymer having the abrasive adsorption parameter less than 5. In addition, the polishing composition S2 does not contain a water-soluble polymer having the abrasive adsorption parameter of 5 or more in a content (concentration) of 0.005% by mass or more. In other words, the concentration of the water-soluble polymer having the abrasive adsorption parameter of 5 or more in the polishing composition S2 is less than 0.005% by mass (less than 0.005% by mass with respect to the total mass of the polishing composition S2). The water-soluble polymer having the abrasive adsorption parameter of 5 or more functions to protect the surfaces of the abrasive. The water-soluble polymer having the abrasive adsorption parameter less than 5 functions to reduce residues on the surface of the substrate.

The abrasive adsorption parameter of a water-soluble polymer can be calculated through the following procedures (1) to (4) :

(1) providing a test liquid L containing colloidal silica (PL-2, manufactured by Fuso Chemical Co., Ltd, average primary particle size: 25 nm, average secondary particle size: 50 nm) in a concentration of 0.08% by mass, a water-soluble polymer to be measured in a concentration of 0.004% by mass, ammonia in a concentration of 0.005% by mass, and the balance of water,
(2) measuring a total organic carbon concentration (TOC value) of the test liquid L, and taking the obtained TOC

value as a total organic carbon concentration $W_0$ [mass ppm] of the water-soluble polymer to be measured contained in the test liquid L,

(3) subjecting the test liquid L to a centrifugation treatment at 26,000 rpm for 30 minutes with a centrifuge such as Avanti HP-30I manufactured by Beckman Coulter, Inc. to separate the test liquid L into a precipitate and a supernatant, measuring a TOC value of the supernatant, and taking the obtained TOC value as a total organic carbon concentration $W_1$ [mass ppm] of the water-soluble polymer to be measured contained in the supernatant, and

(4) calculating an adsorption ratio of the water-soluble polymer to be measured in accordance with the following equation, and taking a value thus obtained as the abrasive adsorption parameter.

[Expression 3]

$$\text{Adsorption Ratio } (\%) = [(W_0 - W_1)/W_0] \times 100$$

The total organic carbon concentration $W_0$ [mass ppm] of the water-soluble polymer to be measured contained in the test liquid L, and the total organic carbon concentration $W_1$ [mass ppm] of the water-soluble polymer to be measured contained in the supernatant obtained by the centrifugation treatment of the test liquid L can be evaluated, for example, with a total organic carbon analyzer TOC-L manufactured by Shimadzu Corporation.

The method for calculating the abrasive adsorption parameter will be described in detail in Examples.

It is presumed that the colloidal silica precipitates through the centrifugation treatment of the test liquid L. It is also presumed that the water-soluble polymer contained in the supernatant obtained by the centrifugation treatment of the test liquid L is mainly a portion that does not adsorb on the colloidal silica in the whole water-soluble polymer.

It is presumed that as the abrasive adsorption parameter is larger, the amount of the water-soluble polymer contained in the supernatant obtained by the centrifugation treatment of the test liquid L is smaller, and the amount of the water-soluble polymer adsorbing onto the colloidal silica is larger. Accordingly, it is supposed that as the abrasive adsorption parameter of the water-soluble polymer is larger, the water-soluble polymer more easily adsorbs onto the abrasive in the actual polishing composition, and hence the adsorption amount is also larger.

The abrasive adsorption parameter of the water-soluble polymer having the abrasive adsorption parameter less than 5 is not especially limited, and is usually 0 or more. Besides, the abrasive adsorption parameter is not especially limited, and is preferably 2 or less. When the parameter is within such a range, surface defects caused on the polished surface of the substrate are further reduced.

The abrasive adsorption parameter of the water-soluble polymer having the abrasive adsorption parameter of 5 or more is not especially limited, and is preferably 60 or more. When the parameter is within this range, surface defects caused on the polished surface of the substrate are further reduced. Besides, the abrasive adsorption parameter is not especially limited, and is usually 100 or less.

The water-soluble polymer used in the present invention is not especially limited, and an example includes a polymer having, in a molecule, at least one functional group selected from the group consisting of cationic groups, anionic groups, and nonionic groups. Specific examples include polymers respectively containing, in a molecule, a hydroxyl group (hydroxy group), a carboxy group or a group of a salt thereof, an acyloxy group, a sulfo group or a group of a salt thereof, a partial structure containing a nitrogen atom (such as an amide group, an amidino group, an imino group, an imide group, a quaternary nitrogen structure, a heterocyclic structure containing a nitrogen atom as a ring-forming atom), a heterocyclic structure containing a hetero atom other than a nitrogen atom as a ring-forming atom, a vinyl structure, and a polyoxyalkylene structure.

The water-soluble polymer having the abrasive adsorption parameter of 5 or more is not especially limited, and preferable examples include a cellulose derivative, a polymer having a partial structure containing a nitrogen atom in a molecule, and a polymer containing two or more hydroxy groups in a molecule and containing an unsubstituted polyoxyalkylene structure. The water-soluble polymer contained in the polishing composition S1 and having the abrasive adsorption parameter of 5 or more preferably contains at least one selected from the group consisting of these compounds.

The cellulose derivative is not especially limited, and examples include hydroxyethyl cellulose, hydroxypropyl cellulose, hydroxyethylmethyl cellulose, hydroxypropylmethyl cellulose, methylcellulose, ethylcellulose, ethylhydroxyethyl cellulose, and carboxymethyl cellulose.

The polymer having a partial structure containing a nitrogen atom in a molecule is not especially limited, and examples include poly(meth)acrylamide, polyalkylaminoalkyl(meth)acrylamide, polyhydroxyalkyl(meth)acrylamide, poly-N-(meth)acryloylmorpholine, poly-N-vinylpyrrolidone, a copolymer containing poly-N-vinylpyrrolidone in a part of the structure, poly-N-vinylimidazole, poly-N-vinylcarbazole, poly-N-vinylcaprolactam, a copolymer containing poly-N-vinylcaprolactam in a part of the structure, poly-N-vinylpiperidine, polyamidine, polyethylene imine, hydrophilic polyimide, various polyamino acids, and an imine derivative such as poly(N-acylalkyleneimine) .

The polymer containing two or more hydroxy groups in a molecule and containing an unsubstituted polyoxyalkylene structure is not especially limited, and examples include polyethylene oxide (PEG), polypropylene oxide (PPO),

polybutylene oxide (PEG), a block copolymer of ethylene oxide (EO) and propylene oxide (PO), and a random copolymer of EO and PO.

Among these, from the viewpoint that surface defects caused on the polished surface of the substrate are further reduced, hydroxyethyl cellulose or poly-N-(meth)acryloylmorpholine is preferred, and poly-N-acryloylmorpholine is more preferred.

The weight average molecular weight of the water-soluble polymer having the abrasive adsorption parameter of 5 or more is not especially limited, and is preferably 1,000 or more, more preferably 10,000 or more, further preferably 100,000 or more, and particularly preferably 200,000 or more. The weight average molecular weight of the water-soluble polymer having the abrasive adsorption parameter of 5 or more can be, for example, 300,000 or more. Besides, the weight average molecular weight of the water-soluble polymer having the abrasive adsorption parameter of 5 or more is not especially limited, and is preferably 2,000,000 or less, more preferably 1,500,000 or less, further preferably 1,000,000 or less, and particularly preferably 500,000 or less. When the weight average molecular weight is within such a range, surface defects caused on the polished surface of the substrate are further reduced. The weight average molecular weight of the water-soluble polymer having the abrasive adsorption parameter of 5 or more can be measured by gel permeation chromatography (GPC) in terms of polyoxyethylene. It is noted that a specific measurement method will be described in Examples. Examples of the preferable weight average molecular weight of the water-soluble polymer having the abrasive adsorption parameter of 5 or more include, but are not limited to, 1,000 or more and 2,000,000 or less, 10,000 or more and 1,500,000 or less, 100,000 or more and 1,000,000 or less, 200,000 or more and 500,000 or less, and 300,000 or more and 500,000 or less.

The water-soluble polymer having the abrasive adsorption parameter less than 5 is not especially limited, and preferable examples include a polymer containing two or more hydroxy groups in a molecule and containing a substituted polyoxyalkylene structure, a polymer containing two or more hydroxy groups in a molecule and containing a vinyl alcohol-derived structural unit, and a polymer having an anionic group in a molecule. The water-soluble polymer contained in the polishing composition S2 and having the abrasive adsorption parameter less than 5 preferably contains at least one selected from the group consisting of these compounds.

In the polymer containing two or more hydroxy groups in a molecule and containing a substituted polyoxyalkylene structure, a substituent for substituting a polyoxyalkylene group is preferably a hydroxy group. The polymer containing two or more hydroxy groups in a molecule, and containing a substituted polyoxyalkylene structure is not especially limited, and an example includes polyglycerin.

In the polymer containing two or more hydroxy groups in a molecule and containing a vinyl alcohol-derived structural unit, the vinyl alcohol-derived structural unit refers to a vinyl alcohol unit (structural portion represented by $-CH_2-CH(OH)-$; hereinafter also referred to as the "VA unit"). The polymer containing two or more hydroxy groups in a molecule and having a vinyl alcohol-derived structural unit may be a copolymer containing, in addition to the VA unit, a non-vinyl alcohol unit (structural unit derived from a monomer other than vinyl alcohol, hereinafter also referred to as the "non-VA unit"). Examples of the non-VA unit are not especially limited, and include structural units derived from ethylene, vinyl acetate, vinyl propionate, vinyl hexanoate, and 2-butenediol. When the polymer containing a vinyl alcohol-derived structural unit contains a non-VA unit, the polymer may contain merely one non-VA unit, or may contain two or more non-VA units. In the polymer containing two or more hydroxy groups in a molecule and containing a vinyl alcohol-derived structural unit, a ratio of the mole number of the VA unit in the mole number of all the repeating units is not especially limited, and is preferably 50% or more, more preferably 65% or more, further preferably 70% or more, and particularly preferably 75% or more (with the upper limit of 100%). All the repeating units may be substantially constituted by the VA units. The degree of saponification of polyvinyl alcohol is not especially limited, and is preferably 50 mol% or more, more preferably 65 mol% or more, further preferably 70 mol% or more, and particularly preferably 75 mol% or more (with the upper limit of 100 mol%). The polymer containing two or more hydroxy groups in a molecule and containing a vinyl alcohol-derived structural unit is not especially limited, and examples include polyvinyl alcohol (PVA), acetalized polyvinyl alcohol, a vinyl alcohol/ethylene copolymer, and a vinyl alcohol/butenediol copolymer. When the polymer containing a vinyl alcohol-derived structural unit is acetalized polyvinyl alcohol, the type of acetalization is not especially limited, and examples include polyvinyl formal, polyvinyl acetoacetal, polyvinyl propyral, polyvinyl ethylal, and polyvinyl butyral. The degree of acetalization is not especially limited, and is preferably 1 mol% or more and 50 mol% or less, more preferably 10 mol% or more and 45 mol% or less, and further preferably 20 mol% or more and 40 mol% or less.

The polymer having an anionic group in a molecule is not especially limited, and preferably includes a polymer having a carboxy group or a group of a salt thereof in a molecule, and a polymer having a sulfo group or a group of a salt thereof in a molecule, and the like. Specific examples include poly(meth)acrylic acid, poly(meth)acrylamide alkylsulfonic acid, polyisoprenesulfonic acid, polyvinylsulfonic acid, polyallylsulfonic acid, polyisoamylenesulfonic acid, polystyrenesulfonic acid, and salts thereof.

Among these, from the viewpoint that surface defects caused on the polished surface of the substrate are further reduced, the polymer containing two or more hydroxy groups in a molecule and having a vinyl alcohol-derived structural unit is preferred, polyvinyl alcohol or acetalized polyvinyl alcohol is more preferred, and acetalized polyvinyl

alcohol is further preferred.

Accordingly, in one preferable embodiment of the present invention, the water-soluble polymer having the abrasive adsorption parameter of 5 or more is at least one polymer selected from the group consisting of a cellulose derivative, a polymer containing a partial structure containing a nitrogen atom in a molecule, and a polymer containing two or more hydroxy groups in a molecule and containing an unsubstituted polyoxyalkylene structure, and the water-soluble polymer having the abrasive adsorption parameter less than 5 is at least one polymer selected from the group consisting of a polymer containing two or more hydroxy groups in a molecule and containing a substituted polyoxyalkylene structure, a polymer containing two or more hydroxy groups in a molecule and containing a vinyl alcohol-derived structural unit, and a polymer containing an anionic group in a molecule.

The weight average molecular weight of the water-soluble polymer having the abrasive adsorption parameter less than 5 is not especially limited as long as it is 1,000 or more, and is preferably 2,000 or more, more preferably 5,000 or more, further preferably 9,000 or more, still further preferably 10,000 or more, and particularly preferably 12,000 or more. Besides, the weight average molecular weight of the water-soluble polymer having the abrasive adsorption parameter less than 5 is not especially limited, and is preferably 2,000,000 or less, more preferably 1,000,000 or less, further preferably 500,000 or less, still further preferably 100,000 or less, and particularly preferably 80,000 or less. When the weight average molecular weight is within such a range, surface defects caused on the polished surface of the substrate are further reduced. Besides, the weight average molecular weight of the water-soluble polymer having the abrasive adsorption parameter less than 5 can be, for example, 50,000 or less. The weight average molecular weight of the water-soluble polymer having the abrasive adsorption parameter less than 5 can be measured by gel permeation chromatography (GPC) in terms of polyoxyethylene. It is noted that a specific measurement method will be described in Examples. Examples of the preferable range of the weight average molecular weight of the water-soluble polymer having the abrasive adsorption parameter less than 5 include, but are not limited to, 2,000 or more and 2,000,000 or less, 5,000 or more and 1,000,000 or less, 9,000 or more and 500,000 or less, 9,000 or more and 100,000 or less, 9,000 or more and 80,000 or less, and 9,000 or more and 50,000 or less.

As each of the water-soluble polymer having the abrasive adsorption parameter of 5 or more and the water-soluble polymer having the abrasive adsorption parameter less than 5, a commercially available product may be used, or a synthesized product may be used. One type each of the water-soluble polymer having the abrasive adsorption parameter of 5 or more and the water-soluble polymer having the abrasive adsorption parameter less than 5 may be singly used, or two or more types each may be used in combination.

The concentration of the water-soluble polymer having the abrasive adsorption parameter of 5 or more in the polishing composition S1 is not especially limited, and is preferably 0.0001% by mass or more, more preferably 0.001% by mass or more, further preferably 0.003% by mass or more, and particularly preferably 0.004% by mass or more with respect to the total mass of the polishing composition S1. When the concentration is within such a range, surface defects caused on the polished surface of the substrate are further reduced. This is probably because the protection effect of the abrasive in the polishing sub-step 1 is further improved. The concentration of the water-soluble polymer having the abrasive adsorption parameter of 5 or more in the polishing composition S1 is not especially limited, and is preferably 1% by mass or less, and more preferably 0.01% by mass or less with respect to the total mass of the polishing composition S1. When the concentration is within such a range, surface defects caused on the polished surface of the substrate are further reduced. This is probably because a smaller amount of the water-soluble polymer having the abrasive adsorption parameter of 5 or more remains after the polishing sub-step 1. Besides, the concentration of the water-soluble polymer having the abrasive adsorption parameter of 5 or more in the polishing composition S1 can be, for example, 0.008% by mass or less, or for example, 0.005% by mass or less with respect to the total mass of the polishing composition S1. Examples of the preferable range of the concentration of the water-soluble polymer having the abrasive adsorption parameter of 5 or more in the polishing composition S1 include, but are not limited to, 0.0001% by mass or more and 1% by mass or less, 0.001% by mass or more and 0.01% by mass or less, 0.003% by mass or more and 0.008% by mass or less, and 0.004% by mass or more and 0.005% by mass or less with respect to the total mass of the polishing composition S1.

When the polishing composition S1 contains the water-soluble polymer having the abrasive adsorption parameter less than 5, the concentration of the water-soluble polymer having the abrasive adsorption parameter less than 5 in the polishing composition S1 is not especially limited, and is preferably 0.0001% by mass or more, more preferably 0.001% by mass or more, further preferably 0.002% by mass or more, and particularly preferably 0.003% by mass or more with respect to the total mass of the polishing composition S1. When the concentration is within such a range, surface defects caused on the polished surface of the substrate are further reduced. This is probably because smaller amounts of the abrasive and the water-soluble polymer having the abrasive adsorption parameter of 5 or more remain after the polishing sub-step 1 owing to the presence of the water-soluble polymer having the abrasive adsorption parameter less than 5. Besides, the concentration of the water-soluble polymer having the abrasive adsorption parameter less than 5 in the polishing composition S1 is not especially limited, and is preferably 1% by mass or less, and more preferably 0.01% by mass or less with respect to the total mass of the polishing composition S1. When the concentration

is within such a range, surface defects caused on the polished surface of the substrate are further reduced. This is probably because inhibition, by the water-soluble polymer having the abrasive adsorption parameter less than 5, of the adsorption onto the substrate of the abrasive and the water-soluble polymer having the abrasive adsorption parameter of 5 or more in the polishing sub-step 1 is more difficult to be caused, and hence the effect of removing defects in the polishing sub-step 1 can be more favorably obtained. Besides, the concentration of the water-soluble polymer having the abrasive adsorption parameter less than 5 in the polishing composition S1 can be, for example, 0.008% by mass or less, and can be, for example, 0.005% by mass or less with respect to the total mass of the polishing composition S1. Examples of the preferable range of the concentration of the water-soluble polymer having the abrasive adsorption parameter less than 5 in the polishing composition S1 include, but are not limited to, 0.0001% by mass or more and 1% by mass or less, 0.001% by mass or more and 0.01% by mass or less, 0.002% by mass or more and 0.008% by mass or less, and 0.003% by mass or more and 0.005% by mass or less with respect to the total mass of the polishing composition S1.

Accordingly, the concentration of the water-soluble polymer in the polishing composition S1 (namely, the sum of the concentration of the water-soluble polymer having the abrasive adsorption parameter of 5 or more and the concentration of the water-soluble polymer having the abrasive adsorption parameter less than 5 in the polishing composition S1; which also applies hereinafter) is not especially limited, and is preferably 0.0001% by mass or more, more preferably 0.001% by mass or more, further preferably 0.003% by mass or more, and particularly preferably 0.004% by mass or more with respect to the total mass of the polishing composition S1. Besides, the concentration of the water-soluble polymer in the polishing composition S1 is not especially limited, and is preferably 2% by mass or less, more preferably 0.02% by mass or less, further preferably 0.016% by mass or less, and particularly preferably 0.01% by mass or less with respect to the total mass of the polishing composition S1. When the concentration is within such a range, surface defects caused on the polished surface of the substrate are further reduced. Examples of the preferable concentration of the water-soluble polymer in the polishing composition S1 include, but are not limited to, 0.0001% by mass or more and 2% by mass or less, 0.001% by mass or more and 0.02% by mass or less, 0.003% by mass or more and 0.016% by mass or less, and 0.004% by mass or more and 0.01% by mass or less with respect to the total mass of the polishing composition S1.

The concentration of the water-soluble polymer having the abrasive adsorption parameter less than 5 in the polishing composition S2 is not especially limited, and is preferably 0.0001% by mass or more, more preferably 0.001% by mass or more, further preferably 0.002% by mass or more, and particularly preferably 0.003% by mass or more with respect to the total mass of the polishing composition S2. When the concentration is within such a range, surface defects caused on the polished surface of the substrate are further reduced. This is probably because the cleaning effect in the polishing sub-step 2, namely, the effect of reducing the abrasive and the water-soluble polymer, is further improved. Besides, the concentration of the water-soluble polymer having the abrasive adsorption parameter less than 5 in the polishing composition S2 is not especially limited, and is preferably 1% by mass or less, more preferably 0.01% by mass or less, and further preferably 0.008% by mass or less with respect to the total mass of the polishing composition S2. When the concentration is within such a range, surface defects caused on the polished surface of the substrate are further reduced. This is probably because a smaller amount of the water-soluble polymer having the abrasive adsorption parameter less than 5 remains after the polishing sub-step 2. Besides, the concentration of the water-soluble polymer having the abrasive adsorption parameter less than 5 in the polishing composition S2 can be, for example, 0.005% by mass or less with respect to the total mass of the polishing composition S2. Examples of the preferable concentration of the water-soluble polymer having the abrasive adsorption parameter less than 5 in the polishing composition S2 include, but are not limited to, 0.0001% by mass or more and 1% by mass or less, 0.001% by mass or more and 0.01% by mass or less, 0.002% by mass or more and 0.008% by mass or less, and 0.003% by mass or more and 0.005% by mass or less with respect to the total mass of the polishing composition S2.

The polishing composition S2 does not contain the water-soluble polymer having the abrasive adsorption parameter of 5 or more in a content (concentration) of 0.005% by mass or more. The concentration of the water-soluble polymer having the abrasive adsorption parameter of 5 or more in the polishing composition S2 is not especially limited as long as it is less than 0.005% by mass (less than 0.005% by mass with respect to the total mass of the polishing composition S2). It is, however, preferable that the polishing composition S2 substantially does not contain the water-soluble polymer having the abrasive adsorption parameter of 5 or more, and it is most preferable that it does not contain the water-soluble polymer having the abrasive adsorption parameter of 5 or more. Herein, that the polishing composition S2 "substantially does not contain the water-soluble polymer having the abrasive adsorption parameter of 5 or more" means that the concentration of the water-soluble polymer having the abrasive adsorption parameter of 5 or more is less than 0.0001% by mass with respect to the total mass of the polishing composition S2. In this case, surface defects caused on the polished surface of the substrate are further reduced. This is probably because a smaller amount of the water-soluble polymer having the abrasive adsorption parameter of 5 or more remains after the polishing sub-step 2, and the effect of removing the abrasive and the water-soluble polymer in the polishing sub-step 2 is more difficult to be inhibited, and therefore, the effect of reducing the abrasive and the water-soluble polymer in the polishing sub-step 2 is

further improved. A preferable concentration of the water-soluble polymer having the abrasive adsorption parameter of 5 or more in the polishing composition S2 is, for example, less than 0.0001% by mass with respect to the total mass of the polishing composition S2, or the water-soluble polymer having the abrasive adsorption parameter of 5 or more is not contained, although not limited thereto.

Accordingly, the concentration of the water-soluble polymer in the polishing composition S2 (namely, the sum of the concentration of the water-soluble polymer having the abrasive adsorption parameter of 5 or more and the concentration of the water-soluble polymer having the abrasive adsorption parameter less than 5 in the polishing composition S2; which also applies hereinafter) is not especially limited, and is preferably 0.0001% by mass or more, more preferably 0.001% by mass or more, further preferably 0.002% by mass or more, and particularly preferably 0.003% by mass or more with respect to the total mass of the polishing composition S2. Besides, the concentration of the water-soluble polymer in the polishing composition S2 is not especially limited, and is preferably 1% by mass or less, more preferably 0.01% by mass or less, further preferably 0.008% by mass or less, and particularly preferably 0.005% by mass or less with respect to the total mass of the polishing composition S2. In these cases, surface defects caused on the polished surface of the substrate are further reduced. Examples of the preferable concentration of the water-soluble polymer in the polishing composition S2 include, but are not limited to, 0.0001% by mass or more and 1% by mass or less, 0.001% by mass or more and 0.01% by mass or less, 0.002% by mass or more and 0.008% by mass or less, and 0.003% by mass or more and 0.005% by mass or less with respect to the total mass of the polishing composition S2.

Accordingly, in one preferable embodiment of the present invention, the concentration of the water-soluble polymer in the polishing composition S1 is 0.0001% by mass or more and 2% by mass or less with respect to the total mass of the polishing composition S1, and the concentration of the water-soluble polymer in the polishing composition S2 is 0.0001% by mass or more and 1% by mass or less with respect to the total mass of the polishing composition S2.

The relationship between the concentration of the water-soluble polymer in the polishing composition S2 and the concentration of the water-soluble polymer in the polishing composition S1 is not especially limited, and the concentration of the water-soluble polymer in the polishing composition S2 is preferably equal to or lower than the concentration of the water-soluble polymer in the polishing composition S1. Besides, the ratio of the concentration of the water-soluble polymer in the polishing composition S2 to the concentration of the water-soluble polymer in the polishing composition S1 (concentration of the water-soluble polymer in the polishing composition S2/concentration of the water-soluble polymer in the polishing composition S1) is not especially limited, and is preferably 0.1 or more and 1 or less, and more preferably 0.2 or more and 0.95 or less. In these cases, surface defects caused on the polished surface of the substrate can be further reduced. Besides, the ratio can be, for example, 0.3 or more and 0.6 or less, and can be, for example, 0.4 or more and 0.5 or less.

(Basic Compound)

The polishing composition S1 and the polishing composition S2 may each independently further contain a basic compound. Besides, it is more preferable that the polishing composition S1 and the polishing composition S2 further contain a basic compound. The basic compound may, depending on the type of the substrate, chemically act on the polished surface of the substrate to chemically polish the substrate in some cases.

The basic compound is not especially limited, and examples include hydroxides of alkali metals or alkaline earth metals, or salts thereof, quaternary ammonium, ammonia, quaternary ammonium hydroxide or a salt thereof, and amine.

Specific examples of the alkali metals are not especially limited, and include potassium and sodium. The alkaline earth metals are not especially limited, and an example includes calcium. Salts of the alkali metals or the alkaline earth metals are not especially limited, and examples include carbonates, bicarbonates, sulfates, and acetates of these. Specific examples of the hydroxides of alkali metals or alkaline earth metals or salts thereof are not especially limited, and include calcium hydroxide, potassium hydroxide, potassium carbonate, potassium bicarbonate, potassium sulfate, potassium acetate, potassium chloride, sodium hydroxide, sodium bicarbonate, sodium carbonate, and calcium hydroxide.

Specific examples of the quaternary ammonium are not especially limited, and include tetramethylammonium, tetraethylammonium, and tetrabutylammonium.

Specific examples of the quaternary ammonium hydroxide or a salt thereof are not especially limited, and include tetramethylammonium hydroxide, tetraethylammonium hydroxide, and tetrabutylammonium hydroxide.

Specific examples of the amine include a compound having a structure represented by the following chemical formula (I), triethylenetetramine, piperazine anhydride, piperazine hexahydrate, 1-(2-aminoethyl)piperazine, N-methylpiperazine, guanidine, and azoles such as imidazole and triazole.

[Chem. 1]

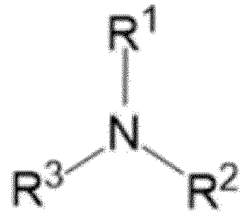

(I)

In the chemical formula (I), $R^1$ to $R^3$ are each independently a hydrogen atom, or a substituted or unsubstituted alkyl group, except where $R^1$ to $R^3$ are all hydrogen atoms.

When each of $R^1$ to $R^3$ is a substituted alkyl group, a substituent contained in the substituted alkyl group is not especially limited, and is preferably a hydroxy group, or a substituted or unsubstituted amino group, and more preferably a hydroxy group or an unsubstituted amino group.

When each of $R^1$ to $R^3$ is a substituted or unsubstituted alkyl group, the number of carbon atoms of the alkyl group (alkyl group before substitution when it is a substituted alkyl group) is not especially limited, and is preferably 1 or more and 6 or less, more preferably 2 or more and 3 or less, and particularly preferably 2.

Preferable specific examples of the amine include, but are not limited to, methylamine, dimethylamine, trimethylamine, ethylamine, diethylamine, triethylamine, ethylenediamine, monoethanolamine, diethanolamine, triethanolamine, N-(β-aminoethyl)ethanolamine, hexamethylenediamine, diethylenetriamine, triethylenetetramine, piperazine anhydride, piperazine hexahydrate, 1-(2-aminoethyl)piperazine, N-methylpiperazine, guanidine, and azoles such as imidazole and triazole. The amine contained in each of the polishing composition S1 and the polishing composition S2 preferably contains at least one compound selected from the group consisting of these compounds.

Among these, quaternary ammonium, ammonia, quaternary ammonium hydroxide or a salt thereof, and amine are preferred. The basic compound contained in the polishing composition S1 is more preferably quaternary ammonium, ammonia, or quaternary ammonium hydroxide or a salt thereof, and further preferably ammonia. The basic compound contained in the polishing composition S1 preferably contains at least one compound selected from the group consisting of these compounds. The basic compound contained in the polishing composition S2 is more preferably ammonia, or the compound having the structure represented by the chemical formula (1), further preferably ammonia, methylamine, dimethylamine, trimethylamine, ethylamine, diethylamine, triethylamine, ethylenediamine, monoethanolamine, diethanolamine, triethanolamine, N-(β-aminoethyl)ethanolamine, hexamethylenediamine, or diethylenetriamine, further preferably ammonia, trimethylamine, ethylamine, diethylamine, triethylamine, or triethanolamine, further preferably trimethylamine, ethylamine, diethylamine, triethylamine, or triethanolamine, further preferably trimethylamine, ethylamine, triethylamine, or triethanolamine, further preferably trimethylamine, ethylamine, or triethylamine, further preferably ethylamine or triethylamine, and particularly preferably triethylamine. The basic compound contained in the polishing composition S2 preferably contains at least one compound selected from the group consisting of these compounds.

As the basic compound, a commercially available product may be used, or a synthesized product may be used. One type of basic compounds may be singly used, or two or more types may be used in combination.

The concentration of the basic compound in the polishing composition S1 is not especially limited, and is preferably 0.0001% by mass or more, more preferably 0.001% by mass or more, further preferably 0.003% by mass or more, and particularly preferably 0.004% by mass or more with respect to the total mass of the polishing composition S1. When the concentration is within such a range, the polishing removal rate is further improved. The concentration of the basic compound in the polishing composition S1 is not especially limited, and is preferably 1% by mass or less, more preferably 0.01% by mass or less, and further preferably 0.008% by mass or less with respect to the total mass of the polishing composition S1. When the concentration is within such a range, surface defects caused on the polished surface of the substrate are further reduced. Examples of the preferable concentration of the basic compound in the polishing composition S1 include, but are not limited to, 0.0001% by mass or more and 1% by mass or less, 0.001% by mass or more and 0.01% by mass or less, 0.003% by mass or more and 0.008% by mass or less, and 0.004% by mass or more and 0.008% by mass or less with respect to the total mass of the polishing composition S1.

The concentration of the basic compound in the polishing composition S2 is not especially limited, and is preferably 0.0001% by mass or more, more preferably 0.0004% by mass or more, further preferably 0.0008% by mass or more, still further preferably 0.001% by mass or more, particularly preferably 0.003% by mass or more, and further particularly preferably 0.004% by mass or more with respect to the total mass of the polishing composition S2. When the concentration is within such a range, surface defects caused on the polished surface of the substrate are further reduced. The concentration of the basic compound in the polishing composition S2 is not especially limited, and is preferably 1% by mass or less, more preferably 0.1% by mass or less, further preferably 0.01% by mass or less, still

further preferably 0.008% by mass or less, particularly preferably 0.005% by mass or less, and further particularly preferably 0.003% by mass or less with respect to the total mass of the polishing composition S2. When the concentration is within such a range, surface defects caused on the polished surface of the substrate are further reduced. Examples of the preferable concentration of the basic compound in the polishing composition S1 include, but are not limited to, 0.0001% by mass or more and 1% by mass or less, 0.0004% by mass or more and 0.1% by mass or less, 0.0008% by mass or more and 0.01% by mass or less, 0.0008% by mass or more and 0.008% by mass or less, 0.0008% by mass or more and 0.005% by mass or less, and 0.0008% by mass or more and 0.003% by mass or less with respect to the total mass of the polishing composition S1.

(Surfactant)

The polishing composition S1 and the polishing composition S2 may each independently further contain a surfactant. It is preferable that the polishing composition S1 and the polishing composition S2 further contain a surfactant. The surfactant functions to inhibit roughening of the polished surface of the substrate and to reduce surface defects. In particular, when the polishing composition contains a basic compound, the polished surface of the substrate tends to be easily roughened through chemical polishing with the basic compound. Therefore, it is particularly effective to use a basic compound and a surfactant together.

The surfactant is not especially limited, and examples include a nonionic surfactant, a cationic surfactant, and an anionic surfactant. Among these, a nonionic surfactant is preferred from the viewpoint of further reducing surface defects caused on the polished surface of the substrate.

The nonionic surfactant is not especially limited, and examples include a single polymer of oxyalkylene, a copolymer of a plurality of types of oxyalkylene, and a polyoxyalkylene adduct. Specific examples of the polyoxyalkylene adduct are not especially limited, and include polyoxyalkylene alkyl ether, polyoxyalkylene alkyl phenyl ether, polyoxyalkylene alkyl amine, polyoxyalkylene fatty acid ester, polyoxyalkylene glyceryl ether fatty acid ester, and polyoxyalkylene sorbitan fatty acid ester.

Specific examples of the nonionic surfactant are not especially limited, and include polyoxyethylene propyl ether, polyoxyethylene butyl ether, polyoxyethylene pentyl ether, polyoxyethylene hexyl ether, polyoxyethylene octyl ether, polyoxyethylene-2-ethylhexyl ether, polyoxyethylene nonyl ether, polyoxyethylene decyl ether, polyoxyethylene isodecyl ether, polyoxyethylene tridecyl ether, polyoxyethylene lauryl ether, polyoxyethylene cetyl ether, polyoxyethylene stearyl ether, polyoxyethylene isostearyl ether, polyoxyethylene oleyl ether, polyoxyethylene phenyl ether, polyoxyethylene octylphenyl ether, polyoxyethylene nonylphenyl ether, polyoxyethylene dodecylphenyl ether, polyoxyethylene styrenated phenyl ether, polyoxyethylene laurylamine, polyoxyethylene stearylamine, polyoxyethylene oleylamine, polyoxyethylene stearylamide, polyoxyethylene oleylamide, polyoxyethylene monolauric acid ester, polyoxyethylene monostearic acid ester, polyoxyethylene distearic acid ester, polyoxyethylene monooleic acid ester, polyoxyethylene dioleic acid ester, polyoxyethylene sorbitan monolaurate, polyoxyethylene sorbitan monopalmitate, polyoxyethylene sorbitan monostearate, polyoxyethylene sorbitan monooleate, polyoxyethylene sorbitan trioleate, polyoxyethylene sorbitol tetraoleate, polyoxyethylene castor oil, and polyoxyethylene hydrogenated castor oil.

Among these, from the viewpoint of further reducing surface defects caused on the polished surface of the substrate, a polyoxyalkylene adduct and the like are preferred, polyoxyalkylene alkyl ether is more preferred, polyoxyethylene alkyl ether is further preferred, and polyoxyethylene decyl ether is particularly preferred.

The molecular weight of the surfactant is not especially limited, and is preferably less than 1,000, more preferably less than 500, and further preferably less than 400. As the molecular weight of the surfactant, a molecular weight calculated based on the chemical formula is preferably employed.

As the surfactant, a commercially available product may be used, or a synthesized product may be used. One type of surfactants may be singly used, or two or more types may be used in combination.

The surfactants contained in the polishing composition S1 and the polishing composition S2 preferably respectively contain nonionic surfactants. Each of the nonionic surfactants contained in the polishing composition S1 and the polishing composition S2 preferably contains at least one selected from the group consisting of the above-described compounds.

The concentration of the surfactant in the polishing composition S1 is not especially limited, and is preferably 0.0001% by mass or more, more preferably 0.0002% by mass or more, and further preferably 0.0004% by mass or more with respect to the total mass of the polishing composition S1. When the concentration is within such a range, surface defects caused on the polished surface of the substrate are further reduced. Besides, the concentration of the surfactant in the polishing composition S1 can be, for example, 0.0006% by mass or more with respect to the total mass of the polishing composition S1. Besides, the concentration of the surfactant in the polishing composition S1 is not especially limited, and is preferably 1% by mass or less, more preferably 0.01% by mass or less, further preferably 0.001% by mass or less, and particularly preferably 0.0008% by mass or less with respect to the total mass of the polishing composition S1. When the concentration is within such a range, the polishing removal rate is further improved. Examples of

the preferable concentration of the surfactant in the polishing composition S1 include, but are not limited to, 0.0001% by mass or more and 1% by mass or less, 0.0002% by mass or more and 0.01% by mass or less, 0.0004% by mass or more and 0.001% by mass or less, and 0.0004% by mass or more and 0.0008% by mass or less with respect to the total mass of the polishing composition S1.

The concentration of the surfactant in the polishing composition S2 is not especially limited, and is preferably 0.0001% by mass or more, more preferably 0.0002% by mass or more, and further preferably 0.0004% by mass or more with respect to the total mass of the polishing composition S2. When the concentration is within such a range, surface defects caused on the polished surface of the substrate are further reduced. Besides, the concentration of the surfactant in the polishing composition S2 can be, for example, 0.0006% by mass or more with respect to the total mass of the polishing composition S2. Besides, the concentration of the surfactant in the polishing composition S2 is not especially limited, and is preferably 1% by mass or less, more preferably 0.01% by mass or less, further preferably 0.001% by mass or less, and particularly preferably 0.0008% by mass or less with respect to the total mass of the polishing composition S2. When the concentration is within such a range, the polishing removal rate is further improved. Examples of the preferable concentration of the surfactant in the polishing composition S2 include, but are not limited to, 0.0001% by mass or more and 1% by mass or less, 0.0002% by mass or more and 0.01% by mass or less, 0.0004% by mass or more and 0.001% by mass or less, and 0.0006% by mass or more and 0.0008% by mass or less with respect to the total mass of the polishing composition S2.

(Dispersion medium)

The polishing composition S1 and the polishing composition S2 contain water as a dispersion medium. The dispersion medium functions to disperse or dissolve the respective components.

The content of water in the dispersion medium is not especially limited, and is preferably 50% by mass or more, more preferably 90% by mass or more with respect to the total mass of the dispersion medium, and the dispersion medium further preferably contains only water. As the water, from the viewpoint of preventing contamination of the object to be polished and inhibition of the functions of other components, water containing impurities as little as possible is preferred. For example, water having a total content of transition metal ions of 100 mass ppb or less is preferred. Here, the purity of the water can be increased by, for example, an operation such as removing impurity ions with an ion exchange resin, removing foreign matters with a filter, a distillation, or the like. Specifically, as the water, for example, deionized water (ion exchange water), pure water, ultrapure water, distilled water or the like is preferably used.

The polishing composition S1 and the polishing composition S2 may each further contain, in addition to the water, an organic solvent as the dispersion medium when dispersibility or solubility of each component can be thus improved. The organic solvent is not especially limited, and known organic solvents can be used. One type of organic solvents may be singly used, or two or more types may be used in combination.

(Other Components)

The polishing composition S1 and the polishing composition S2 may, each independently, further contain other components other than the above-described components as long as the effects of the present invention are not impaired. Other components are not especially limited, and examples include known components that can be used in a polishing composition and a rinse polishing composition. Specific examples are not especially limited, and include, but are not limited to, an acid, a chelating agent, an antiseptic agent, an antifungal agent, a dissolved gas, and a reducing agent.

(Method for Producing Polishing Composition)

A method for producing the polishing composition S1 is not especially limited as long as it includes mixing the abrasive 1, the water-soluble polymer having the abrasive adsorption parameter of 5 or more, water, and other components added if necessary. Besides, a method for producing the polishing composition S2 is not especially limited as long as it includes mixing the abrasive 2, the water-soluble polymer having the abrasive adsorption parameter less than 5, water, and other components added if necessary.

A mixing method for mixing the respective components is not especially limited, and any of known methods can be appropriately employed. Besides, a mixing temperature is not especially limited, and is generally preferably 10°C or more and 40°C or less, and heating may be implemented for increasing the rate of dissolution. A mixing time is also not especially limited.

[Object to be Polished]

In a polishing method according to one embodiment of the present invention, the substrate corresponding to

the object to be polished is not especially limited, and is preferably a semiconductor substrate. Therefore, it can be said that another aspect of the present invention relates to a method for producing a semiconductor substrate including polishing a substrate by the above-described polishing method. Examples of the substrate include a substrate consisting of a single layer, and a substrate including a layer to be polished, and another layer (such as a supporting layer or another functional layer).

In a polishing method according to one embodiment of the present invention, the substrate corresponding to the object to be polished is not especially limited, and preferably contains a material having a silicon-silicon bond. The material having a silicon-silicon bond is not especially limited, and examples include polysilicon, amorphous silicon, single crystal silicon, n-doped single crystal silicon, p-doped single crystal silicon, and a Si-based alloy such as SiGe. Among these, from the viewpoint that the effects of the present invention can be more remarkably obtained, single crystal silicon, n-doped single crystal silicon, or p-doped single crystal silicon is preferred, and p-doped single crystal silicon is more preferred. Single one of these materials having a silicon-silicon bond can be singly used, or two or more of these can be used in combination.

Accordingly, the substrate is preferably a silicon substrate (silicon wafer).

<Polishing Composition Set>

Another aspect of the present invention relates to a polishing composition set to be used in a method for polishing a substrate, wherein the polishing method includes a polishing step, the polishing step includes two or more polishing sub-steps of polishing the substrate by rotating a platen while supplying a polishing composition to a contact surface between the substrate and a polishing pad attached to the platen, the two or more polishing sub-steps include a polishing sub-step 1 of performing polishing on a platen, and a polishing sub-step 2 of performing, after the polishing sub-step 1, polishing on the platen used in the polishing sub-step 1, the polishing composition set including: a polishing composition S1 for use in the polishing sub-step 1, containing an abrasive 1, water, and a water-soluble polymer having an abrasive adsorption parameter calculated through the following procedures (1) to (4) of 5 or more, and a polishing composition S2 for use in the polishing sub-step 2, containing an abrasive 2, water, and a water-soluble polymer having the abrasive adsorption parameter less than 5, but not containing a water-soluble polymer having the abrasive adsorption parameter of 5 or more in a content of 0.005% by mass or more (namely, a concentration of the water-soluble polymer having the abrasive adsorption parameter of 5 or more in the polishing composition S2 is less than 0.005% by mass with respect to the total mass of the polishing composition S2):

(1) providing a test liquid L containing colloidal silica having an average primary particle size of 25 nm and an average secondary particle size of 50 nm in a concentration of 0.08% by mass, a water-soluble polymer to be measured in a concentration of 0.004% by mass, ammonia in a concentration of 0.005% by mass, and the balance of water,
(2) measuring a total organic carbon concentration (TOC value) of the test liquid L, and taking the obtained TOC value as a total organic carbon concentration $W_0$ [mass ppm] of the water-soluble polymer to be measured contained in the test liquid L,
(3) subjecting the test liquid L to a centrifugation treatment at 26,000 rpm for 30 minutes to separate the test liquid L into a precipitate and a supernatant, then measuring a TOC value of the supernatant, and taking the obtained TOC value as a total organic carbon concentration $W_1$ [mass ppm] of the water-soluble polymer to be measured contained in the supernatant, and
(4) calculating an adsorption ratio of the water-soluble polymer to be measured in accordance with the following equation, and taking a value thus obtained as the abrasive adsorption parameter.

[Expression 4]

$$\text{Adsorption Ratio (\%)} = [(W_0 - W_1)/W_0] \times 100$$

According to the present aspect, means capable of reducing surface defects on a polished substrate can be provided.

The details of the polishing method are the same as those described above. The details of the polishing step, other steps, the polishing composition S1, the polishing composition S2, the object to be polished, and the like are the same as those described above.

It is preferable that the polishing composition S1 is a final polishing composition, and the polishing composition S2 is a rinse polishing composition.

The polishing composition set may further include, in addition to the polishing composition S1 and the polishing composition S2, one, two or more other polishing compositions if necessary. At this point, it is preferable that the polishing composition S1 is a final polishing composition, the polishing composition S2 is a rinse polishing composition, and other

polishing compositions are the pre-polishing compositions or the final polishing compositions. Besides, it is more preferable that the polishing composition S1 is a final polishing composition, the polishing composition S2 is a rinse polishing composition, and other polishing compositions are the pre-polishing compositions.

Besides, each polishing composition included in the polishing composition set may be in a concentrated form. The concentrated form refers to a form of a concentrate of the polishing composition, and can be grasped as a stock solution of the polishing composition. The concentration factor is not especially limited, and can be, for example, about twice or more and 100 times or less in terms of volume, and is suitable to be usually about 5 times or more and 50 times or less, and for example, 10 times or more and 40 times or less. Such a concentrate can be used in such a manner as to be diluted at desired timing to prepare a polishing composition, and to supply the polishing composition to an object to be polished. Dilution can be performed, for example, by adding water to the concentrate to be mixed.

## Examples

The present invention will be described in more details using Examples and Comparative Examples below. The technical scope of the present invention is, however, not limited to only the following Examples. It is noted that "%" and "parts" respectively mean "% by mass" and "parts by mass" unless otherwise stated.

<Polishing Composition>

[Preparation of Polishing Composition]

Polishing compositions were respectively prepared by mixing, in deionized water (DIW), the following materials to obtain compositions shown in Tables 2 to 5 below.

- Abrasive

Silica A: colloidal silica, having an average primary particle size obtained by a BET method of 35 nm and an average secondary particle size obtained by a dynamic light scattering method of 70 nm,
Silica B: colloidal silica, having an average primary particle size obtained by a BET method of 25 nm and an average secondary particle size obtained by a dynamic light scattering method of 50 nm,
Silica C: colloidal silica, having an average primary particle size obtained by a BET method of 15 nm and an average secondary particle size obtained by a dynamic light scattering method of 35 nm.

- Water-soluble Polymer

PVA: polyvinyl alcohol (weight average molecular weight: 70,000, degree of saponification: 98% by mol or more),
Ac-PVA: acetalized polyvinyl alcohol (weight average molecular weight: 13,000, type of acetalization: polyvinyl ethylal, degree of acetalization: 30% by mol),
Ac-PVA (2): acetalized polyvinyl alcohol (weight average molecular weight: 9,700, type of acetalization: polyvinyl ethylal, degree of acetalization: 24% by mol),
HEC: hydroxyethyl cellulose (weight average molecular weight: 250,000),
PACMO: poly-N-acryloylmorpholine (weight average molecular weight: 350,000).

- Basic Compound

$NH_3$: ammonia water (concentration: 29% by mass; values shown in Table 2 and Table 4 below being in terms of the amount of ammonia),
Triethylamine,
Trimethylamine,
Diethylamine,
Ethylamine,
Triethanolamine.

- Surfactant

C10EO5: polyoxyethylene decyl ether ($C_{10}H_{21}O(CH_2CH_2O)_5H$, molecular weight: 378) .

[Weight Average Molecular Weight]

The weight average molecular weight of the water-soluble polymer was measured by a GPC method under the following conditions.

<<Conditions for Measuring Weight Average Molecular Weight>>

Evaluation apparatus: HLC-8320GPC (Tosoh Corporation)
Sample concentration: 0.1% by mass
Column: TSKgel GMPWXL
Detector: differential refractometer
Eluent: 100 mM sodium nitrate aqueous solution
Flow rate: 1 mL/min
Measurement temperature: 40°C
Sample injection amount: 200 μL
(in terms of polyoxyethylene).

[Abrasive Adsorption Parameter]

The abrasive adsorption parameter of the water-soluble polymer was calculated through the following procedures (1) to (4).

<<Conditions for Evaluating Adsorption Parameter>>

(1) A test liquid L containing colloidal silica (PL-2 manufactured by Fuso Chemical Co., Ltd., average primary particle size: 25 nm, average secondary particle size: 50 nm) in a concentration of 0.08% by mass, the water-soluble polymer to be measured in a concentration of 0.004% by mass, ammonia in a concentration of 0.005% by mass, and the balance of water was provided,
(2) the total organic carbon concentration (TOC value) of the test liquid L was measured, and the obtained TOC value was taken as the total organic carbon concentration $W_0$ [mass ppm] of the water-soluble polymer to be measured contained in the test liquid L,
(3) the test liquid L was subjected to a centrifugation treatment at 26,000 rpm for 30 minutes with Avanti HP-30I manufactured by Beckman Coulter Inc. to separate the test liquid L into a precipitate and a supernatant, the TOC value of the supernatant was then measured, and the obtained TOC value was taken as the total organic carbon concentration $W_1$ [mass ppm] of the water-soluble polymer to be measured contained in the supernatant, and
(4) the adsorption ratio of the water-soluble polymer to be measured was calculated in accordance with the following equation, and a value thus obtained was taken as the abrasive adsorption parameter.

[Expression 5]

$$\text{Adsorption Ratio (\%)} = [(W_0 - W_1)/W_0] \times 100$$

Here, the total organic carbon concentration $W_0$ [mass ppm] of the water-soluble polymer to be measured contained in the test liquid L, and the total organic carbon concentration $W_1$ [mass ppm] of the water-soluble polymer to be measured contained in the supernatant obtained by the centrifugation treatment of the test liquid L were evaluated using a total organic carbon analyzer TOC-L manufactured by Shimadzu Corporation.

The values of the abrasive adsorption parameters are shown in Tables 2 to 5 below. It is noted that Tables 2 to 5 below show a water-soluble polymer having the abrasive adsorption parameter less than 5 as a "water-soluble polymer X", and a water-soluble polymer having the abrasive adsorption parameter of 5 or more as a "water-soluble polymer Y".

<Polishing Method>

A silicon wafer was polished by a polishing method including a polishing step including respective polishing sub-steps shown in Table 1 below. Polishing conditions in each polishing sub-step of the polishing method of Examples and Comparative Examples were as follows.

Besides, in the polishing method of each of the Examples and Comparative Examples, the polishing composition obtained as described above was used as a final polishing composition used in the final polishing sub-step, and the rinse polishing composition used in the rinse polishing sub-step, respectively. Compositions of these polishing compositions are shown in Tables 2 to 5 below.

[Pre-polishing Sub-step]

A single crystal silicon wafer (diameter: 300 mm, p-type, <100> crystalline orientation, COP free) was subjected to single side polishing using the following pre-polishing composition on a platen 1 of the following polishing machine under the following polishing conditions.

<<Pre-polishing Compositions>>

Pre-polishing composition: To deionized water (DIW) used as a dispersion medium mixing was performed such that colloidal silica (abrasive, average primary particle size obtained by a BET method: 35 nm, average secondary particle size obtained by a dynamic light scattering method: 70 nm) was 0.6% by mass, TMAH (tetramethylammonium hydroxide) was 0.08% by mass, and HEC (hydroxyethyl cellulose, weight average molecular weight: 1,200,000) was 0.0002% by mass with respect to the total mass of a polishing composition to obtain the polishing composition.

<<Polishing Conditions in Pre-polishing Sub-step>>

Polishing machine: Single Wafer Polishing machine "PNX 332B" manufactured by Okamoto Machine Tool Works, Ltd.
Polishing load: 20 kPa
Platen rotational speed: 20 rpm
Template rotational speed: 20 rpm
Polishing pad: trade name "FP55" manufactured by FUJIBO EHIME Co., Ltd.
Supply rate of polishing composition: 1 L/min
Temperature of polishing composition: 20°C
Temperature of platen cooling water: 20°C.

[Final Polishing Sub-step (Polishing Sub-step 1 of the Invention)]

Subsequently, the single crystal silicon wafer having been polished in the pre-polishing sub-step was subjected to single side polishing using the final polishing composition shown in Tables 2 and 3 with the polishing machine used in the pre-polishing sub-step on a platen 2 different from the platen 1 under the following polishing conditions.

<<Polishing Conditions in Final Polishing Sub-step>>

Polishing machine: Single Wafer Polishing machine "PNX 332B" manufactured by Okamoto Machine Tool Works, Ltd.
Polishing load: 20 kPa
Platen rotational speed: 52 rpm
Template rotational speed: 50 rpm
Polishing pad: trade name "POLYPAS(R) 275NX" manufactured by FUJIBO EHIME Co., Ltd.
Supply rate of polishing liquid: 1.5 L/min
Temperature of polishing liquid: 20°C
Temperature of platen cooling water: 20°C.

[Rinse Polishing Sub-step (Polishing Sub-step 2 of the Invention)]

Then, the single crystal silicon wafer having been polished in the final polishing sub-step was subjected to single side polishing using the rinse polishing composition shown in Tables 4 and 5 with the polishing machine used in the pre-polishing sub-step and the final polishing sub-step on the platen 2 used in the final polishing sub-step under the same polishing conditions as those in the final polishing sub-step.

[Cleaning]

A first cleaning tank holding a cleaning liquid of $NH_4OH$ (29% by mass):$H_2O_2$ (31% by mass):deionized water (DIW) = 2:5.3:48 (in a volume ratio) kept at 70°C, and a second cleaning tank holding ultrapure water of 25°C were provided. Then, the single crystal silicon wafer having been polished through the rinse polishing sub-step described above was immersed in the first cleaning tank for 6 minutes, then immersed in the second cleaning tank for 15 minutes with an ultrasonic oscillator operated, immersed again in the first cleaning tank for 6 minutes, and then immersed in the second cleaning tank for 16 minutes with the ultrasonic oscillator operated, and the resultant was dried. Thus, a polished silicon wafer was obtained.

[Table 1]

| (Table 1) Each Polishing Sub-step included in Polishing Step and Polishing time | | | |
|---|---|---|---|
| | Pre-polishing Sub-step | Final Polishing Sub-step | Rinse Polishing Sub-step |
| Polishing Composition | Pre-polishing Composition | Final Polishing Composition | Rinse Polishing Composition |
| Platen | 1 | 2 | 2 |
| Polishing Time [sec] | 240 | 210 | 30 |

[Table 2]

(Table 2) Composition of Final Polishing Composition used in Final Polishing Sub-step

| Polishing Method | Final Polishing Composition | | | | | | | | | |
|---|---|---|---|---|---|---|---|---|---|---|
| | Abrasive (silica) | | Basic Compound (ammonia) | Water-soluble Polymer X | | | Water-soluble Polymer Y | | | Surfactant (C10EO5) |
| | Type | Concentration [mass%] | Concentration [mass%] | Type | Abrasive Adsorption Parameter | Concentration [mass%] | Type | Abrasive Adsorption Parameter | Concentration [mass%] | Concentration [mass%] |
| Example 1 | Silica A | 0.10 | 0.005 | not contained | | 0 | HEC | 55 | 0.009 | 0.0005 |
| Example 2 | Silica A | 0.10 | 0.005 | not contained | | 0 | HEC | 55 | 0.009 | 0.0005 |
| Example 3 | Silica B | 0.10 | 0.005 | PVA | 2 | 0.008 | PACMO | 90 | 0.006 | 0.0006 |
| Example 4 | Silica B | 0.08 | 0.005 | Ac-PVA | 1 | 0.003 | PACMO | 90 | 0.004 | 0.0006 |
| Comparative Example 1 | Silica A | 0.10 | 0.005 | not contained | | 0 | HEC | 55 | 0.009 | 0.0005 |
| Comparative Example 2 | Silica A | 0.10 | 0.005 | not contained | | 0 | HEC | 55 | 0.009 | 0.0005 |
| Comparative Example 3 | Silica B | 0.10 | 0.005 | PVA | 2 | 0.008 | not contained | | 0 | 0.0006 |
| Comparative Example 4 | Silica B | 0.10 | 0.005 | PVA | 2 | 0.008 | not contained | | 0 | 0.0005 |

[Table 3]

(Table 3) Composition of Final Polishing Composition used in Final Polishing Sub-step

| Polishing Method | Final Polishing Composition | | | | | | | | | |
|---|---|---|---|---|---|---|---|---|---|---|
| | Abrasive (silica) | | Basic Compound (ammonia) | Water-soluble Polymer X | | | Water-soluble Polymer Y | | | Surfactant (C10E05) |
| | Type | Concentration [mass%] | Concentration [mass%] | Type | Abrasive Adsorption Parameter | Concentration [mass%] | Type | Abrasive Adsorption Parameter | Concentration [mass%] | Concentration [mass%] |
| Example 5 | Silica B | 0.08 | 0.005 | Ac-PVA (2) | 1 | 0.003 | PACMO | 90 | 0.004 | 0.0006 |
| Example 6 | Silica B | 0.08 | 0.005 | Ac-PVA (2) | 1 | 0.003 | PACMO | 90 | 0.004 | 0.0006 |
| Example 7 | Silica B | 0.08 | 0.005 | Ac-PVA (2) | 1 | 0.003 | PACMO | 90 | 0.004 | 0.0006 |
| Example 8 | Silica B | 0.08 | 0.005 | Ac-PVA (2) | 1 | 0.003 | PACMO | 90 | 0.004 | 0.0006 |
| Example 9 | Silica B | 0.08 | 0.005 | Ac-PVA (2) | 1 | 0.003 | PACMO | 90 | 0.004 | 0.0006 |
| Example 10 | Silica B | 0.08 | 0.005 | Ac-PVA (2) | 1 | 0.003 | PACMO | 90 | 0.004 | 0.0006 |

[Table 4]

(Table 4) Composition of Rinse Polishing Composition used in Rinse Polishing Sub-step

| Polishing Method | Rinse Polishing Composition | | | | | | | | | |
|---|---|---|---|---|---|---|---|---|---|---|
| | Abrasive (silica) | | Basic Compound (ammonia) | Water-soluble Polymer X | | | Water-soluble Polymer Y | | | Surfactant (C10E05) |
| | Type | Concentration [mass%] | Concentration [mass%] | Type | Abrasive Adsorption Parameter | Concentration [mass%] | Type | Abrasive Adsorption Parameter | Concentration [mass%] | Concentration [mass%] |
| Example 1 | Silica B | 0.08 | 0.005 | PVA | 2 | 0.008 | not contained | | 0 | 0.0006 |
| Example 2 | Silica C | 0.05 | 0.005 | PVA | 2 | 0.008 | not contained | | 0 | 0.0006 |
| Example 3 | Silica B | 0.10 | 0.005 | PVA | 2 | 0.008 | not contained | | 0 | 0.0006 |
| Example 4 | Silica B | 0.08 | 0.005 | Ac-PVA | 1 | 0.003 | not contained | | 0 | 0.0006 |
| Comparative Example 1 | Silica A | 0.10 | 0.005 | not contained | | 0 | HEC | 55 | 0.009 | 0.0005 |
| Comparative Example 2 | Silica B | 0.08 | 0.005 | PVA | 2 | 0.008 | PACMO | 90 | 0.006 | 0.0006 |
| Comparative Example 3 | Silica B | 0.05 | 0.005 | PVA | 2 | 0.008 | not contained | | 0 | 0.0006 |
| Comparative Example 4 | Silica B | 0.08 | 0.005 | PVA | 2 | 0.008 | PACNO | 90 | 0.006 | 0.0006 |

[Table 5]

(Table 5) Composition of Rinse Polishing Composition used in Rinse Polishing Sub-step

| Polishing Method | Rinse Polishing Composition | | | | | | | | | | |
|---|---|---|---|---|---|---|---|---|---|---|---|
| | Abrasive (silica) | | Basic Compound | | Water-soluble Polymer X | | | Water-soluble Polymer Y | | | Surfactant (C10E05) |
| | Type | Concentration [mass%] | Type | Concentration [mass%] | Type | Abrasive Adsorption Parameter | Concentration [mass%] | Type | Abrasive Adsorption Parameter | Concentration [mass%] | Concentration [mass%] |
| Example 5 | Silica B | 0.08 | Ammonia | 0.0003 | Ac-PVA(2) | 1 | 0.003 | not contained | | 0 | 0.0006 |
| Example 6 | Silica B | 0.08 | Triethylamine | 0.0009 | Ac-PVA(2) | 1 | 0.003 | not contained | | 0 | 0.0006 |
| Example 7 | Silica B | 0.08 | Trimethylamine | 0.0006 | Ac-PVA(2) | 1 | 0.003 | not contained | | 0 | 0.0006 |
| Example 8 | Silica B | 0.08 | Diethylamine | 0.0006 | Ac-PVA(2) | 1 | 0.003 | not contained | | 0 | 0.0006 |
| Example 9 | Silica B | 0.08 | Ethylamine | 0.0004 | Ac-PVA(2) | 1 | 0.003 | not contained | | 0 | 0.0006 |
| Example 10 | Silica B | 0.08 | Triethanolamine | 0.0075 | Ac-PVA(2) | 1 | 0.003 | not contained | | 0 | 0.0006 |

<Evaluation>

[Number of Defects on Polished Silicon Wafer]

The number of defects on the polished silicon wafer obtained as described was evaluated first with an optical inspection apparatus (wafer inspection apparatus) "SURFSCAN SP5" manufactured by KLA-TENCOR Corporation with a measurement mode set to DC mode. Results thus obtained are shown in Table 6 below as a ratio (%) to the number of defects in Comparative Example 2 assuming that the number of defects in Comparative Example 2 is 100%.

[Table 6]

| (Table 6) Number of Defects on Polished Silicon Wafer caused in Each Polishing Method | |
|---|---|
| Polishing Method | Number of Defects (%) |
| Example 1 | 85 |
| Example 2 | 84 |
| Example 3 | 72 |
| Example 4 | 65 |
| Comparative Example 1 | 103 |
| Comparative Example 2 | 100 |
| Comparative Example 3 | <1000 |
| Comparative Example 4 | 100 |
| Example 5 | 70 |
| Example 6 | 25 |
| Example 7 | 41 |
| Example 8 | 68 |
| Example 9 | 31 |
| Example 10 | 49 |

It was confirmed, based on the results shown in Tables 1 to 6, that on substrates polished by the polishing methods of Examples 1 to 10 according to the present invention, the numbers of defects were remarkably small. On the other hand, it was also confirmed that on substrates polished by the polishing methods of Comparative Examples 1 to 4 out of the scope of the present invention, the numbers of defects were greatly large as compared with those on the substrates polished by the polishing methods of Examples 1 to 10 according to the present invention.

This application is based upon the Japanese Patent Application No. 2021-052791, filed on March 26, 2021, the entire contents of which are incorporated herein by reference.

## Claims

**1.** A method for polishing a substrate, comprising a polishing step,

wherein the polishing step includes two or more polishing sub-steps of polishing the substrate by rotating a platen while supplying a polishing composition to a contact surface between the substrate and a polishing pad attached to the platen,
the two or more polishing sub-steps include:

a polishing sub-step 1 of performing polishing on the platen using a polishing composition S1, and
a polishing sub-step 2 of performing, after the polishing sub-step 1, polishing on the platen used in the polishing sub-step 1 using a polishing composition S2,
the polishing composition S1 contains an abrasive 1, water, and a water-soluble polymer having an abrasive adsorption parameter calculated through the following procedures (1) to (4) of 5 or more, and

the polishing composition S2 contains an abrasive 2, water, and a water-soluble polymer having the abrasive adsorption parameter less than 5, but does not contain a water-soluble polymer having the abrasive adsorption parameter of 5 or more in a content of 0.005% by mass or more:

(1) providing a test liquid L containing colloidal silica having an average primary particle size of 25 nm and an average secondary particle size of 50 nm in a concentration of 0.08% by mass, a water-soluble polymer to be measured in a concentration of 0.004% by mass, ammonia in a concentration of 0.005% by mass, and the balance of water,
(2) measuring a total organic carbon concentration (TOC value) of the test liquid L, and taking the obtained TOC value as a total organic carbon concentration $W_0$ of the water-soluble polymer to be measured contained in the test liquid L,
(3) subjecting the test liquid L to a centrifugation treatment at 26,000 rpm for 30 minutes to separate the test liquid L into a precipitate and a supernatant, then measuring a TOC value of the supernatant, and taking the obtained TOC value as a total organic carbon concentration $W_1$ of the water-soluble polymer to be measured contained in the supernatant, and
(4) calculating an adsorption ratio of the water-soluble polymer to be measured in accordance with the following equation, and taking a value thus obtained as the abrasive adsorption parameter.

[Expression 1]

$$\text{Adsorption Ratio (\%)} = [(W_0 - W_1)/W_0] \times 100.$$

**2.** The polishing method according to claim 1,

wherein a concentration of the abrasive 1 in the polishing composition S1 is 0.001% by mass or more and 3% by mass or less with respect to a total mass of the polishing composition S1, and
a concentration of the abrasive 2 in the polishing composition S2 is 0.001% by mass or more and 3% by mass or less with respect to a total mass of the polishing composition S2.

**3.** The polishing method according to claim 1 or 2, wherein a concentration of the abrasive 2 in the polishing composition S2 is equal to or lower than a concentration of the abrasive 1 in the polishing composition S1.

**4.** The polishing method according to any one of claims 1 to 3, wherein an average primary particle size of the abrasive 2 is equal to or smaller than an average primary particle size of the abrasive 1.

**5.** The polishing method according to any one of claims 1 to 4, wherein the abrasive 1 and the abrasive 2 are silica.

**6.** The polishing method according to any one of claims 1 to 5,

wherein a concentration of a water-soluble polymer in the polishing composition S1 is 0.0001% by mass or more and 2% by mass or less with respect to a total mass of the polishing composition S1, and
a concentration of a water-soluble polymer in the polishing composition S2 is 0.0001% by mass or more and 1% by mass or less with respect to a total mass of the polishing composition S2.

**7.** The polishing method according to any one of claims 1 to 6, wherein a concentration of a water-soluble polymer in the polishing composition S2 is equal to or lower than a concentration of a water-soluble polymer in the polishing composition S1.

**8.** The polishing method according to any one of claims 1 to 7,

wherein the water-soluble polymer having the abrasive adsorption parameter of 5 or more is at least one polymer selected from the group consisting of a cellulose derivative, a polymer containing a partial structure containing a nitrogen atom in a molecule, and a polymer containing two or more hydroxy groups in a molecule and containing an unsubstituted polyoxyalkylene structure, and
the water-soluble polymer having the abrasive adsorption parameter less than 5 is at least one polymer selected from the group consisting of a polymer containing two or more hydroxy groups in a molecule and containing a substituted polyoxyalkylene structure, a polymer containing two or more hydroxy groups in a molecule and containing a vinyl alcohol-derived structural unit, and a polymer containing an anionic group in a molecule.

**9.** The polishing method according to any one of claims 1 to 8, wherein the polishing composition S1 and the polishing composition S2 further contain a basic compound.

**10.** The polishing method according to any one of claims 1 to 9, wherein the polishing composition S1 and the polishing composition S2 further contain a surfactant.

**11.** The polishing method according to any one of claims 1 to 10, wherein a polishing time in the polishing sub-step 2 is shorter than a polishing time in the polishing sub-step 1.

**12.** The polishing method according to any one of claims 1 to 11, wherein the substrate is a silicon wafer.

**13.** A method for producing a semiconductor substrate, comprising polishing the substrate by the polishing method according to any one of claims 1 to 12.

**14.** A polishing composition set to be used in a method for polishing a substrate,

wherein the polishing method includes a polishing step,
the polishing step includes two or more polishing sub-steps of polishing the substrate by rotating a platen while supplying a polishing composition to a contact surface between the substrate and a polishing pad attached to the platen,
the two or more polishing sub-steps include:

a polishing sub-step 1 of performing polishing on a platen, and
a polishing sub-step 2 of performing, after the polishing sub-step 1, polishing on the platen used in the polishing sub-step 1,

the polishing composition set comprising:

a polishing composition S1 for use in the polishing sub-step 1, containing an abrasive 1, water, and a water-soluble polymer having an abrasive adsorption parameter calculated through the following procedures (1) to (4) of 5 or more, and
a polishing composition S2 for use in the polishing sub-step 2, containing an abrasive 2, water, and a water-soluble polymer having the abrasive adsorption parameter less than 5, but not containing a water-soluble polymer having the abrasive adsorption parameter of 5 or more in a content of 0.005% by mass or more:

(1) providing a test liquid L containing colloidal silica having an average primary particle size of 25 nm and an average secondary particle size of 50 nm in a concentration of 0.08% by mass, a water-soluble polymer to be measured in a concentration of 0.004% by mass, ammonia in a concentration of 0.005% by mass, and the balance of water,
(2) measuring a total organic carbon concentration (TOC value) of the test liquid L, and taking the obtained TOC value as a total organic carbon concentration $W_0$ of the water-soluble polymer to be measured contained in the test liquid L,
(3) subjecting the test liquid L to a centrifugation treatment at 26,000 rpm for 30 minutes to separate the test liquid L into a precipitate and a supernatant, then measuring a TOC value of the supernatant, and taking the obtained TOC value as a total organic carbon concentration $W_1$ of the water-soluble polymer to be measured contained in the supernatant, and
(4) calculating an adsorption ratio of the water-soluble polymer to be measured in accordance with the following equation, and taking a value thus obtained as the abrasive adsorption parameter.

[Expression 2]

$$\text{Adsorption Ratio (\%)} = [(W_0 - W_1)/W_0] \times 100.$$

**INTERNATIONAL SEARCH REPORT**

International application No.
**PCT/JP2022/012724**

**A. CLASSIFICATION OF SUBJECT MATTER**

***C09G 1/02***(2006.01)i; ***C09K 3/14***(2006.01)i; ***B24B 37/00***(2012.01)i; ***H01L 21/304***(2006.01)i
FI: H01L21/304 622D; H01L21/304 621; B24B37/00 H; C09K3/14 550D; C09K3/14 550Z; C09G1/02

According to International Patent Classification (IPC) or to both national classification and IPC

**B. FIELDS SEARCHED**

Minimum documentation searched (classification system followed by classification symbols)

C09G1/02; C09K3/14; B24B37/00; H01L21/304

Documentation searched other than minimum documentation to the extent that such documents are included in the fields searched

Published examined utility model applications of Japan 1922-1996
Published unexamined utility model applications of Japan 1971-2022
Registered utility model specifications of Japan 1996-2022
Published registered utility model applications of Japan 1994-2022

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| A | WO 2018/043504 A1 (FUJIMI INCORPORATED) 08 March 2018 (2018-03-08) entire text, all drawings | 1-14 |
| A | JP 2017-183478 A (FUJIMI INCORPORATED) 05 October 2017 (2017-10-05) entire text, all drawings | 1-14 |
| A | WO 2019/187837 A1 (FUJIMI INCORPORATED) 03 October 2019 (2019-10-03) entire text, all drawings | 1-14 |
| A | JP 2019-179837 A (FUJIMI INCORPORATED) 17 October 2019 (2019-10-17) entire text, all drawings | 1-14 |
| A | JP 2019-179890 A (FUJIMI INCORPORATED) 17 October 2019 (2019-10-17) entire text, all drawings | 1-14 |
| A | WO 2018/216733 A1 (FUJIMI INCORPORATED) 29 November 2018 (2018-11-29) entire text, all drawings | 1-14 |

☐ Further documents are listed in the continuation of Box C. ☑ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| **02 June 2022** | **14 June 2022** |

| Name and mailing address of the ISA/JP | Authorized officer |
|---|---|
| **Japan Patent Office (ISA/JP)**<br>**3-4-3 Kasumigaseki, Chiyoda-ku, Tokyo 100-8915**<br>**Japan** | Telephone No. |

Form PCT/ISA/210 (second sheet) (January 2015)

**INTERNATIONAL SEARCH REPORT**
**Information on patent family members**

International application No.
**PCT/JP2022/012724**

| Patent document cited in search report | Publication date (day/month/year) | Patent family member(s) | Publication date (day/month/year) |
|---|---|---|---|
| WO 2018/043504 A1 | 08 March 2018 | EP 3508550 A1<br>entire text, all drawings<br>CN 109673157 A<br>KR 10-2019-0045249 A | |
| JP 2017-183478 A | 05 October 2017 | (Family: none) | |
| WO 2019/187837 A1 | 03 October 2019 | KR 10-2020-0128387 A<br>CN 111954705 A | |
| JP 2019-179837 A | 17 October 2019 | KR 10-2020-0128387 A<br>CN 111954705 A | |
| JP 2019-179890 A | 17 October 2019 | (Family: none) | |
| WO 2018/216733 A1 | 29 November 2018 | (Family: none) | |

Form PCT/ISA/210 (patent family annex) (January 2015)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2017183478 A
- JP 2021052791 A